# EUROPEAN PATENT APPLICATION

(11) **EP 4 557 370 A1**
(43) Date of publication of application: **21.05.2025**
(21) Application number: 22954413.5
(22) Date of filing: 10.08.2022
(51) Int. Cl.: H01L 27/102

(54) **THREE-DIMENSIONAL STORAGE ARRAY, MEMORY AND ELECTRONIC DEVICE**

(71) Applicant: Huawei Technologies Co., Ltd., Shenzhen, Guangdong 518129 (CN)
(72) Inventor: HUANG, Kailiang, Shenzhen, Guangdong 518129 (CN); JING, Weiliang, Shenzhen, Guangdong 518129 (CN); SUN, Ying, Shenzhen, Guangdong 518129 (CN); WANG, Zhengbo, Shenzhen, Guangdong 518129 (CN); LIAO, Heng, Shenzhen, Guangdong 518129 (CN)
(74) Representative: Goddar, Heinz J.
(86) International application number: PCT/CN2022/111458
(87) International publication number: WO 2024/031438

(57) **Abstract**

Embodiments of this application provide a three-dimensional memory array, a memory, a method for forming the memory array, and an electronic device, and relates to the field of semiconductor memory technologies, to increase integration density of a memory cell. The memory includes a substrate and a plurality of storage layers, where each storage layer includes a first electrode line, a second electrode line, and a plurality of memory cells, each memory cell includes a first transistor and a second transistor that are electrically connected to each other, and each storage layer includes a first metal layer and a first dielectric layer that are stacked in a direction perpendicular to the substrate. The first electrode line, the second electrode line, and a first electrode, a second electrode, and at least a part of a channel layer of each of the first transistor and the second transistor are located in the first metal layer. These structures are integrated into the same metal layer, so that multiple layers of the memory cell can be simultaneously manufactured, to simplify a manufacturing process.

## Description

### TECHNICAL FIELD

This application relates to the field of semiconductor storage technologies, and in particular, to a three-dimensional memory array, a memory including the three-dimensional memory array, a method for forming the three-dimensional memory array, and an electronic device including the memory.

### BACKGROUND

In a computing system, for example, as a memory structure, a dynamic random access memory (dynamic random access memory, DRAM) may be used to temporarily store computing data of a central processing unit (central processing unit, CPU) and exchange data with an external memory like a hard disk drive, and is a very important part of the computing system.

With development of a memory to higher density and a larger bandwidth, memory cells of various structures emerge, for example, a 2T0C memory cell in a DRAM, and a 1T1C memory cell or a 2TnC memory cell in a ferroelectric memory, where T represents a transistor (transistor), and C represents a capacitor (capacitor).

For example, in a memory cell including at least two transistors, an area occupied by a transistor process structure may affect integration density of the memory cell, and further affect storage capacity of the memory.

At present, to increase storage density, there are a plurality of different process structures for a transistor. However, a plurality of arrangement manners of the transistor pose a challenge to a manufacturing process. As a result, an increase of the integration density of the memory cell is limited.

### SUMMARY

This application provides a three-dimensional memory array, a memory including the three-dimensional memory array, a method for forming the three-dimensional memory array, and an electronic device including the memory. A main objective is to provide a memory array that can increase storage density and can also simplify a manufacturing process.

To achieve the foregoing objective, the following technical solutions are used in embodiments of this application.

According to a first aspect, this application provides a three-dimensional memory array. For example, the three-dimensional memory array may be used in a dynamic random access memory (dynamic random access memory, DRAM).

The three-dimensional memory array includes a substrate and a plurality of storage layers formed on the substrate, where the plurality of storage layers are stacked in a direction perpendicular to the substrate, and each storage layer includes a first electrode line, a second electrode line, and a plurality of memory cells. Each memory cell includes a first transistor and a second transistor that are electrically connected to each other. For example, the memory cell may be of a 2T0C memory cell structure. The first transistor and the second transistor each include a gate, a first electrode, a second electrode, and a channel layer.

The first electrode of the first transistor is electrically connected to the first electrode line, and the first electrode of the second transistor is connected to the second electrode line. The gate of the first transistor may be electrically connected to a third electrode line, and the second electrode of the second transistor may be electrically connected to a fourth electrode line. For example, when the memory cell is a 2T0C memory cell in the DRAM, the first electrode line herein may be a write bit line, the second electrode line is a read bit line, the third electrode line is a write word line, and the fourth electrode line is a read word line.

Each storage layer includes a first metal layer and a first dielectric layer that are stacked in the direction perpendicular to the substrate. The first electrode line, the second electrode line, and the first electrode, the second electrode, and at least a part of the channel layer of each of the first transistor and the second transistor are located in the first metal layer.

In each of the plurality of memory cells provided in this application, the first electrode, the second electrode, and the channel layer of each of the first transistor and the second transistor are located in the first metal layer parallel to the substrate, that is, the first transistor and the second transistor are arranged in a direction parallel to the substrate. Therefore, the memory cells with this structure may be stacked in the direction perpendicular to the substrate and in the direction parallel to the substrate, to implement three-dimensional stacking, implement high-density integration, and increase storage capacity, so as to adapt to a data amount of computation of a processor.

In addition, in this application, the first electrode line (for example, a WBL), the second electrode line (for example, an RBL), and
the first electrode, the second electrode, and at least the part of the channel layer of the transistor are located in the first metal layer parallel to the substrate, rather than that the first electrode, the second electrode, and the channel layer are located in one metal layer and the first electrode line and the second electrode line are located in another metal layer.

Therefore, when the memory array in this application is manufactured, a plurality of dielectric layers and a plurality of semiconductor layers may be first alternately stacked, and then structures of these stacked layers are processed, so that multiple layers of memory cells can be simultaneously processed. For example, when 10 dielectric layers and 10 semiconductor layers are alternately stacked, after one processing process is completed, 10 layers of memory cells may be simultaneously manufactured, and the first electrode line and the second electrode line may be simultaneously manufactured. In other words, in this application, multiple layers of devices may be simultaneously processed, that is, the multiple layers of devices are formed at one time without first manufacturing a first-layer memory array and then manufacturing a second-layer memory array, a third-layer memory array, and the like by layer through a same process. In this way, from a perspective of a process, a technical process can be simplified, and manufacturing costs can be reduced. Especially for a memory array having a large quantity of three-dimensional stacked layers, process complexity and manufacturing costs are obviously reduced. In addition, a phenomenon of poor memory cell alignment accuracy caused by layer-by-layer manufacturing of the memory arrays can be avoided.

In a possible implementation, one part of the channel layer of each of the first transistor and the second transistor is located in the first metal layer, and the other part of the channel layer extends to the first dielectric layer.

Alternatively, the channel layer of each of the first transistor and the second transistor is totally located in the first metal layer.

In a possible implementation, the memory array further includes a third electrode line and a fourth electrode line. Both the third electrode line and the fourth electrode line extend in the direction perpendicular to the substrate. The third electrode line is electrically connected to gates offirst transistors in every two adjacent storage layers. The fourth electrode line is electrically connected to second electrodes of second transistors in every two adjacent storage layers.

In other words, in this embodiment provided in this application, the first electrode line and the second electrode line extend in the direction parallel to the substrate, and the third electrode line and the fourth electrode line extend in the direction perpendicular to the substrate. In a possible implementation, the channel layer of the first transistor is a first channel layer, and the channel layer of the second transistor is a second channel layer. The first channel layer and the second channel layer are arranged perpendicularly to each other. An extension direction of the first electrode line and an extension direction of the second electrode line are consistent with an extension direction of the second channel layer.

For example, the first channel layer extends in a first direction, and the second channel layer, the first electrode line, and the second electrode line all extend in a second direction perpendicular to the first direction.

That the first channel layer extends in a first direction may be understood as that a current direction in the first channel layer is the first direction. That the second channel layer extends in a second direction may be understood as that a current direction in the second channel layer is the second direction.

In a possible implementation, one end that is of the first channel layer and that is close to the second channel layer is electrically isolated from the second channel layer through a gate dielectric layer formed at an interface between the first channel layer and the second channel layer.

In this embodiment, the first channel layer not only serves as a channel of the first transistor, but also serves as the gate of the second transistor. This can simplify a process structure, and can further increase storage density.

In a possible implementation, a concave cavity is formed at a position that is of the second channel layer and that is close to the first channel layer, and one end of the first channel layer is disposed in the concave cavity, and is electrically isolated from the second channel layer through the gate dielectric layer formed on an inner wall of the concave cavity.

The concave cavity disposed on the second channel layer is used to dispose the first channel layer in the concave cavity, to further reduce an area occupied by the memory cell, further increase storage density, and increase storage capacity of the memory array.

In a possible implementation, the gate of the second transistor is formed at an end part of the first channel layer embedded in the concave cavity, the gate of the second transistor is electrically isolated from the second channel layer through the gate dielectric layer formed on the inner wall of the concave cavity, and the gate of the second transistor shares a same electrode with the second electrode of the first transistor.

Compared with the foregoing manner of electrically isolating the first channel layer from the second channel layer directly through the gate dielectric layer, in this implementation, a gate structure of the second transistor is further introduced, and the gate of the second transistor is electrically isolated from the second channel layer through the gate dielectric layer.

In a possible implementation, the memory array further includes a fifth electrode line, and each memory cell further includes at least one ferroelectric capacitor. The ferroelectric capacitor includes a first ferroelectric electrode, a ferroelectric film layer, and a second ferroelectric electrode, the first ferroelectric electrode is electrically connected to the second electrode of the first transistor and the gate of the second transistor, and the second ferroelectric electrode is electrically connected to the fifth electrode line. The first ferroelectric electrode, and the first electrode, the second electrode, and the channel layer of each of the first transistor and the second transistor are located in the same metal layer parallel to the substrate. The fifth electrode line extends in the direction perpendicular to the substrate.

Because the memory cell further includes at least one capacitor, a 2TnC memory cell may be formed. The 2TnC memory cell may be used in a ferroelectric random access memory (ferroelectric random access memory, FeRAM).

In addition, in the 2TnC memory cell, the first ferroelectric electrode, and the first electrode, the second electrode, and the channel layer of each of the first transistor and the second transistor are located in the same metal layer parallel to the substrate. Therefore, the memory arrays in this application may be simultaneously processed, that is, the multiple layers of devices are formed at one time.

In a possible implementation, an extension direction of the first ferroelectric electrode is consistent with an extension direction of the first channel layer, and the first ferroelectric electrode is formed at one end that is of the first channel layer and that is close to the second channel layer, and is electrically isolated from the second channel layer through a gate dielectric layer. The second ferroelectric electrode is disposed on a side surface of the first ferroelectric electrode, and is electrically isolated from the first ferroelectric electrode through the ferroelectric film layer.

In a possible implementation, a concave cavity is formed at a position that is of the second channel layer and that is close to the first ferroelectric electrode, and one end of the first ferroelectric electrode is disposed in the concave cavity, and is electrically isolated from the second channel layer through the gate dielectric layer formed on an inner wall of the concave cavity.

The first ferroelectric electrode is disposed in the concave cavity of the second channel layer, to further reduce an area occupied by the memory cell, and integrate more memory cells per a unit area, thereby increasing storage capacity.

In a possible implementation, each memory cell includes a plurality of ferroelectric capacitors, and the plurality of ferroelectric capacitors are spaced from each other in a direction parallel to the extension direction of the first channel layer.

Therefore, the memory cell is referred to as a 2TnC memory cell including a plurality of ferroelectric capacitors.

In a possible implementation, the first electrode line that is perpendicular to the extension direction of the first channel layer and that is in contact with and electrically connected to the first channel layer is formed at one end that is of the first channel layer and that is away from the second channel layer.

In some examples, the first electrode line herein may not only serve as a WBL, but also serve as a source or a drain of the first transistor.

In a possible implementation, the third electrode line perpendicular to the substrate is formed on a side surface of the first channel layer, and the third electrode line is electrically isolated from the first channel layer through the gate dielectric layer.

In some examples, the third electrode line herein may not only serve as a WWL, but also serve as the gate of the first transistor. The gate of the first transistor may be of a double-gate structure, a single-gate structure, or a gate-all-around structure.

In a possible implementation, the first electrode and the second electrode of the second transistor are formed at two opposite ends of the second channel layer.

In a possible implementation, the second electrode line is located on a side that is of the second channel layer and that is away from the first channel layer. The memory cell further includes a conductive connection portion, and the first electrode of the second transistor is electrically connected to the second electrode line through the conductive connection portion.

The first electrode of the second transistor is led out by the conductive connection portion, to be electrically connected to the second electrode line.

In a possible implementation, the first electrode of the second transistor, the second electrode line, and the conductive connection portion are all manufactured in a semiconductor layer through a doping process.

Certainly, the first electrode, the second electrode line, and the conductive connection portion may also be made of a metal material.

In a possible implementation, the fourth electrode line extending in the direction perpendicular to the substrate is in contact with the other end in the two opposite ends of the second channel layer.

In some examples, the fourth electrode line may not only serve as an RWL, but also serve as the second electrode of the second transistor.

In a possible implementation, the plurality of memory cells include a first memory cell and a second memory cell; the first memory cell and the second memory cell are arranged in a direction parallel to the substrate; and in either the first memory cell or the second memory cell, the first electrode of the first transistor is electrically connected to the first electrode line, and the first electrode of the second transistor is connected to the second electrode line.

That is, the first memory cell and the second memory cell that are disposed in the direction parallel to the substrate may share the first electrode line and the second electrode line.

In a possible implementation, the plurality of memory cells include a first memory cell and a third memory cell; the first memory cell and the third memory cell are stacked in the direction perpendicular to the substrate; and in either the first memory cell or the third memory cell, the gate of the first transistor is electrically connected to the third electrode line, and the second electrode of the second transistor is electrically connected to the fourth electrode line.

The first memory cell and the third memory cell that are disposed in the direction perpendicular to the substrate may share the third electrode line and the fourth electrode line.

In a possible implementation, the plurality of memory cells, the first electrode line, the second electrode line, the third electrode line, and the fourth electrode line are all formed on the substrate through a back-end-of-line process.

Both the first transistor and the second transistor are manufactured through the back-end-of-line process, and the controller may be manufactured through a front-end-of-line process. The controller may include one or more circuits of a decoder, a driver, a time sequence controller, a buffer, or an input/output driver, and may further include another functional circuit. The controller may control the first electrode line, the second electrode line, the third electrode line, and the fourth electrode line in embodiments of this application. After the front-end-of-line process FEOL is completed, an interconnection line and the memory array are manufactured through the back-end-of-line BEOL process. This can increase circuit density per unit area, and further improve storage performance per unit area.

In a possible implementation, the memory array is a DRAM memory array.

Therefore, the memory cell is understood as a 2T0C memory cell in the DRAM memory array.

In a possible implementation, when the memory cell is understood as the 2T0C memory cell in the DRAM memory array, the first electrode line is a write bit line, the second electrode line is a read bit line, the third electrode line is a write word line, and the fourth electrode line is a read word line.

In a possible implementation, the memory array is a ferroelectric memory array.

In a possible implementation, the memory array further includes a fifth electrode line, and each memory cell further includes at least one ferroelectric capacitor. The ferroelectric capacitor includes a first ferroelectric electrode, a ferroelectric film layer, and a second ferroelectric electrode, the first ferroelectric electrode is electrically connected to the second electrode of the first transistor and the gate of the second transistor, and the second ferroelectric electrode is electrically connected to the fifth electrode line. The first electrode line is a write bit line, the second electrode line is a read bit line, the third electrode line is a pre-charge line, the fourth electrode line is a source line, and the fifth electrode line is a word line.

According to a second aspect, this application further provides a memory. The memory includes a controller and the memory array in any one of the foregoing implementations, the controller is electrically connected to the memory array, and the controller is configured to control reading/writing of the memory array.

The memory provided in this application includes the memory array in the foregoing implementations, and in the memory array, a first transistor and a second transistor are arranged in a direction parallel to a substrate. Therefore, memory cells with this structure can be stacked in a direction perpendicular to the substrate and in the direction parallel to the substrate, to implement three-dimensional stacking, implement high-density integration, and increase storage capacity.

In a possible implementation, the memory array and the controller are integrated into a same chip, and the chip is disposed on a base plate.

In a possible implementation, the memory array is integrated into a first chip, the controller is integrated into a second chip, and both the first chip and the second chip are disposed on the base plate through an electrical connection structure.

In a possible implementation, the memory array is integrated into a first chip, the controller is integrated into a second chip, and the first chip and the second chip are stacked and integrated on the base plate.

According to a third aspect, this application further provides an electronic device, including a processor and the memory in any one of the foregoing implementations, where the processor is electrically connected to the memory, and the memory is configured to store data generated by the processor.

The electronic device provided in embodiments of this application includes the memory in any one of the foregoing implementations. Therefore, the electronic device provided in embodiments of this application and the memory in the foregoing technical solutions can resolve a same technical problem, and achieve same expected effect.

According to a fourth aspect, this application further provides a method for forming a memory array. The forming method includes:
forming a plurality of semiconductor layers and a plurality of dielectric layers on a substrate, where the plurality of semiconductor layers and the plurality of dielectric layers are alternately stacked in a direction perpendicular to the substrate; and
performing patterning processing on each semiconductor layer to form a first electrode line, a second electrode line, and a memory cell including a first transistor and a second transistor.

The first transistor and the second transistor each include a first electrode, a second electrode, a gate, and a channel layer, the first electrode of the first transistor is electrically connected to the first electrode line, the first electrode of the second transistor is electrically connected to the second electrode line, the first electrode line, the second electrode line, and the first electrode, the second electrode, and at least a part of the channel layer of each of the first transistor and the second transistor are located in a first metal layer parallel to the substrate, and the first metal layer is parallel to the dielectric layer.

In the method for forming the memory array provided in this application, the plurality of alternately disposed semiconductor layers and dielectric layers are first stacked, and then patterning is performed on each semiconductor layer, to form the first electrode, the second electrode, and the channel layer of each of the first transistor and the second transistor, the first electrode line, and the second electrode line. It may also be understood that, multiple layers of memory cells may be simultaneously manufactured, and the memory cells do not need to be stacked layer by layer. This not only can simplify a manufacturing process, and but also can avoid a problem of a large alignment process difficulty caused during multi-layer stacking.

In a possible implementation, before the performing patterning processing on each semiconductor layer to form a first electrode line, a second electrode line, and a memory cell including a first transistor and a second transistor, the forming method further includes: disposing a plurality of first vias, where the plurality of first vias are spaced from each other in a first direction, and any first via penetrates the plurality of semiconductor layers and the plurality of dielectric layers in the direction perpendicular to the substrate; and filling the first via with an insulation layer. The insulation layer is formed to electrically isolate two adjacent memory cells.

In a possible implementation, the performing patterning processing on each semiconductor layer to form a first electrode line, a second electrode line, and a memory cell including a first transistor and a second transistor includes: disposing a first groove on each semiconductor layer, where the first groove includes a first part extending in the first direction and a second part located between two adjacent insulation layers; forming a gate dielectric layer on a wall surface of the first groove; filling the second part with a semiconductor material, to form the channel layer of the first transistor; and filling the first part with a conductive material, to form the first electrode line extending in the first direction.

In a possible implementation, the first groove is disposed on each semiconductor layer, and the first groove includes the first part extending in the first direction and the second part located between the two adjacent insulation layers. The second part exceeds the side surface that is of the insulation layer and that is away from the first part, to form the concave cavity in the semiconductor layer, so that the channel layer of the first transistor is disposed in the concave cavity.

In the memory cell formed in this way, the channel layer of the first transistor is embedded into the channel layer of the second transistor. This can further reduce an area of the memory cell, and increase storage density.

In a possible implementation, the performing patterning on each semiconductor layer to form a first electrode line, a second electrode line, and a memory cell including a first transistor and a second transistor further includes: disposing a second groove on each semiconductor layer, where the second groove includes a third part extending in the first direction and a fourth part located between channel layers of two adjacent first transistors; and filling both the third part and the fourth part with an insulation layer.

In a possible implementation, after the disposing a second groove on each semiconductor layer, the forming method further includes: doping the semiconductor layer that extends in the first direction and that is adjacent to the third part of the second groove, to form the second electrode line extending in the first direction, and doping the semiconductor layer that is adjacent to the channel layer of the first transistor, to form the first electrode that is of the second transistor and that is electrically connected to the second electrode line.

In this implementation, the semiconductor layer is doped to form the first electrode of the second transistor and the second electrode line. This can simplify a process.

In a possible implementation, forming a fourth electrode line includes: disposing second vias on the semiconductor layer on two opposite sides of the fourth part, so that the second vias penetrate the plurality of semiconductor layers and the plurality of dielectric layers in the direction perpendicular to the substrate; and filling the second via with a conductive material, to form a fourth electrode line.

In a possible implementation, forming a third electrode line includes: disposing a third via on a side surface of the channel layer of the first transistor, so that the third via penetrates the plurality of semiconductor layers and the plurality of dielectric layers in the direction perpendicular to the substrate; and filling the third via with a conductive material, to form a third electrode line.

Third vias may be disposed on two opposite sides of the first channel layer, to form a gate-all-around first transistor; or a third via may be disposed on one side in two opposite sides of the first channel layer, to form a single-gate first transistor.

### BRIEF DESCRIPTION OF DRAWINGS

FIG. 1 is a diagram of a circuit in an electronic device according to an embodiment of this application;
FIG. 2 is a diagram of a circuit of a memory according to an embodiment of this application;
FIG. 3a is a diagram of a package structure for a memory array and a controller according to an embodiment of this application;
FIG. 3b is a diagram of a package structure for a memory array and a controller according to an embodiment of this application;
FIG. 3c is a diagram of a package structure for a memory array and a controller according to an embodiment of this application;
FIG. 4 is a diagram of a three-dimensional structure of a memory according to an embodiment of this application;
FIG. 5 is a simple diagram of a circuit of a memory according to an embodiment of this application;
FIG. 6 is a schematic of a circuit of one memory cell in a memory according to an embodiment of this application;
FIG. 7 is a schematic of a circuit of one memory cell in a memory according to an embodiment of this application;
FIG. 8 is a diagram of a position relationship between a memory cell and a substrate in a memory according to an embodiment of this application;
FIG. 9 is a simple three-dimensional diagram of a memory according to an embodiment of this application;
FIG. 10 is a sectional view of a process structure of one memory cell in a memory according to an embodiment of this application;
FIG. 11 is a three-dimensional view of one memory cell in a memory according to an embodiment of this application;
FIG. 12 is a top view of FIG. 11;
FIG. 13a is a simple two-dimensional diagram of a memory according to an embodiment of this application;
FIG. 13b is a simple two-dimensional diagram of a memory according to an embodiment of this application;
FIG. 14 is a sectional view of a process structure of one memory cell in a memory according to an embodiment of this application;
FIG. 15 is a sectional view of a process structure of a second transistor of one memory cell in a memory according to an embodiment of this application;
FIG. 16 is a sectional view of a process structure of one memory cell in a memory according to an embodiment of this application;
FIG. 17 is a sectional view of a process structure of one memory cell in a memory according to an embodiment of this application;
FIG. 18 is a three-dimensional view of a memory array formed by a plurality of memory cells in a memory according to an embodiment of this application;
FIG. 19 is a sectional view of a process structure of a memory array formed by a plurality of memory cells in a memory according to an embodiment of this application;
FIG. 20 is a three-dimensional view of multiple layers of memory arrays in a memory according to an embodiment of this application;
FIG. 21 is a sectional view of a process structure of one memory cell in a memory according to an embodiment of this application;
FIG. 22 is a sectional view of a process structure of one memory cell in a memory according to an embodiment of this application;
FIG. 23 is a sectional view of a process structure of one memory cell in a memory according to an embodiment of this application;
FIG. 24 is a sectional view of a process structure of one memory cell in a memory according to an embodiment of this application;
FIG. 25 is a sectional view of a process structure of a memory array formed by a plurality of memory cells in a memory according to an embodiment of this application;
FIG. 26 is a block diagram of a procedure of a method for manufacturing a memory array according to an embodiment of this application; and
FIG. 27a to FIG. 27m are sectional views of corresponding process structures after steps in a method for manufacturing a memory are completed according to an embodiment of this application.

Reference numerals:
100: substrate;
200: electronic device;
300: memory;
31: memory array;
32: controller;
33: base plate;
400, 400A, 400B, 400C, 400D, 401, 402, 403, 404: memory cell;
T1: first transistor, namely, write transistor;
T2: second transistor, namely, read transistor;
11, 21: first electrode; 12, 22: second electrode; 13, 23: channel layer;
41, 42: gate;
51: gate dielectric layer;
61: first electrode line; 62: second electrode line; 63: third electrode line; 64: fourth electrode line; 65: fifth electrode line;
7: conductive connection portion;
81: first ferroelectric electrode; 82: ferroelectric film layer; 83: second ferroelectric electrode;
10: semiconductor layer;
20: dielectric layer;
201: first groove; 201A: first part; 201B: second part;
301, 302, 303: via;
401, 402: insulation layer.

### DESCRIPTION OF EMBODIMENTS

The following describes embodiments in this application with reference to accompanying drawings.

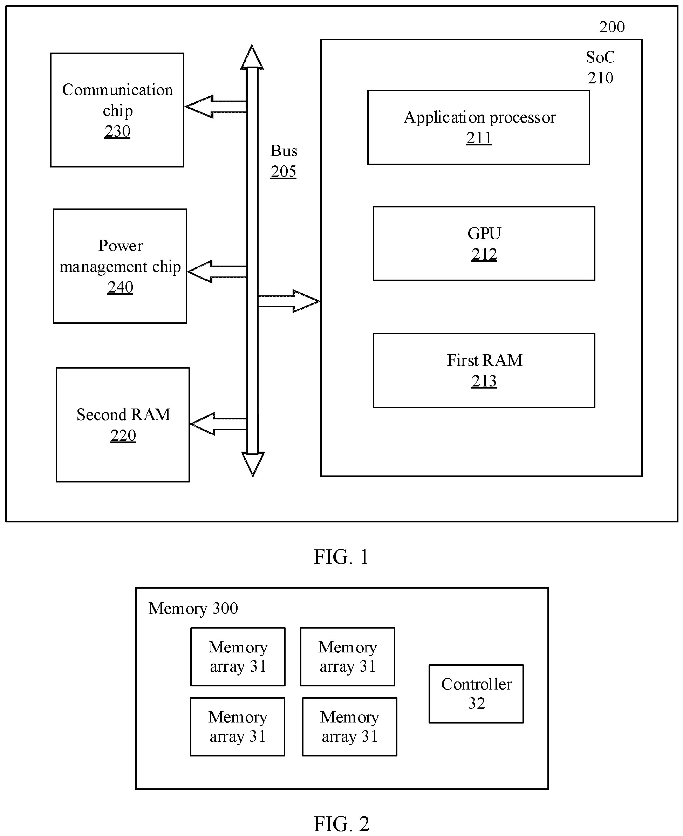

An embodiment of this application provides an electronic device. FIG. 1 is a block diagram of a circuit in an electronic device 200 according to an embodiment of this application. The electronic device 200 may be a terminal device, for example, a mobile phone, a tablet computer, or a smart band, or may be a personal computer (personal computer, PC), a server, a workstation, or the like.

As shown in FIG. 1, the electronic device 200 may include a bus 205 and a system on chip (system on chip, SoC) 210 connected to the bus 205. The SoC 210 may be configured to process data, for example, process data of an application program, process image data, and cache temporary data. In an implementation, the SoC 210 may include an application processor (application processor, AP) 211 configured to process an application program, a graphics processing unit (graphics processing unit, GPU) 212 configured to process image data, and a first random access memory (random access memory, RAM) 213 configured to cache high-speed data. The first RAM 213 may be a static random access memory (static random access memory, SRAM), an embedded flash (embedded flash, eflash), or the like. The AP 211, the GPU 212, and the first RAM 213 may be integrated into one die (die), or may be disposed in a plurality of dies respectively.

As shown in FIG. 1, the electronic device 200 may further include a second RAM 220 connected to the SoC 210 through the bus 205. The second RAM 220 may be a dynamic random access memory (dynamic random access memory, DRAM). The second RAM 220 may be configured to store volatile data, for example, temporary data generated by the SoC 210. Storage capacity of the second RAM 220 is usually greater than that of the first RAM 213, but a read speed of the second RAM 220 is usually less than that of the first RAM 213.

In addition, the electronic device 200 may further include a communication chip 230 and a power management chip 240 that are connected to the SoC 210 through the bus 205. The communication chip 230 may be configured to process a protocol stack, or perform processing such as amplification and filtering on an analog radio frequency signal, or implement the foregoing functions at same time. The power management chip 240 may be configured to supply power to another chip. In an implementation, the SoC 210 and the second RAM 220 may be packaged in a package structure, for example, 2.5D (dimension) or 3D packaging is used, to obtain a higher inter-chip data transmission rate.

FIG. 2 is a block diagram of a circuit of a memory 300 that can be used in an electronic device according to an embodiment of this application. In an implementation, the memory 300 may be the first RAM 213 shown in FIG. 1, or may be the second RAM 220. An application scenario of the memory 300 in this application is not limited.

As shown in FIG. 2, the memory 300 includes a memory array 31 and a controller 32 configured to access the memory array 31. The controller 32 is configured to control a read/write operation of the memory array 31.

The memory array 31 and the controller 32 shown in FIG. 2 have a plurality of implementable package structures. For example, the following provides several implementable package structures.

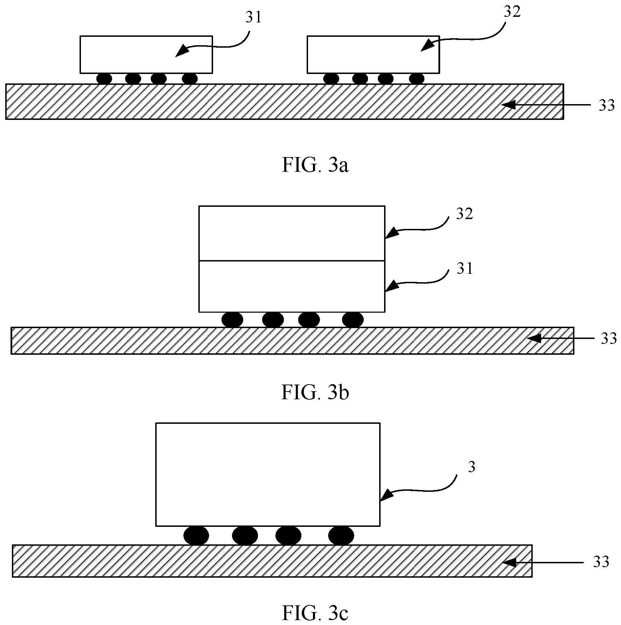

FIG. 3a shows a package structure for the memory array 31 and the controller 32 according to an embodiment of this application. To be specific, the memory array 31 and the controller 32 are two chips independent of each other, and the memory array 31 and the controller 32 are separately integrated on a base plate 33. For example, the memory array 31 and the controller 32 may be electrically connected to each other through metal traces disposed on the base plate 33. In this structure, the memory array 31 and the controller 32 are two independent chips. Therefore, the memory array 31 may be referred to as a stand-alone (stand-alone) memory.

FIG. 3b shows another package structure for the memory array 31 and the controller 32 according to an embodiment of this application. In this structure, similar to those in FIG. 3a, the memory array 31 and the controller 32 are two chips independent of each other. Therefore, the memory array 31 may also be referred to as a stand-alone memory. Different from FIG. 3a, in FIG. 3b, the memory array 31 and the controller 32 are stacked. For example, the memory array 31 and the controller 32 may be connected to each other through a through silicon via (through silicon via, TSV) or a redistribution layer (redistribution layer, RDL).

FIG. 3c shows still another package structure for the memory array 31 and the controller 32 according to an embodiment of this application. In this example structure, the memory array 31 and the controller 32 are integrated on a same chip 3, and the chip 3 is integrated on the base plate 33. Therefore, the memory array 31 may be referred to as an embedded memory.

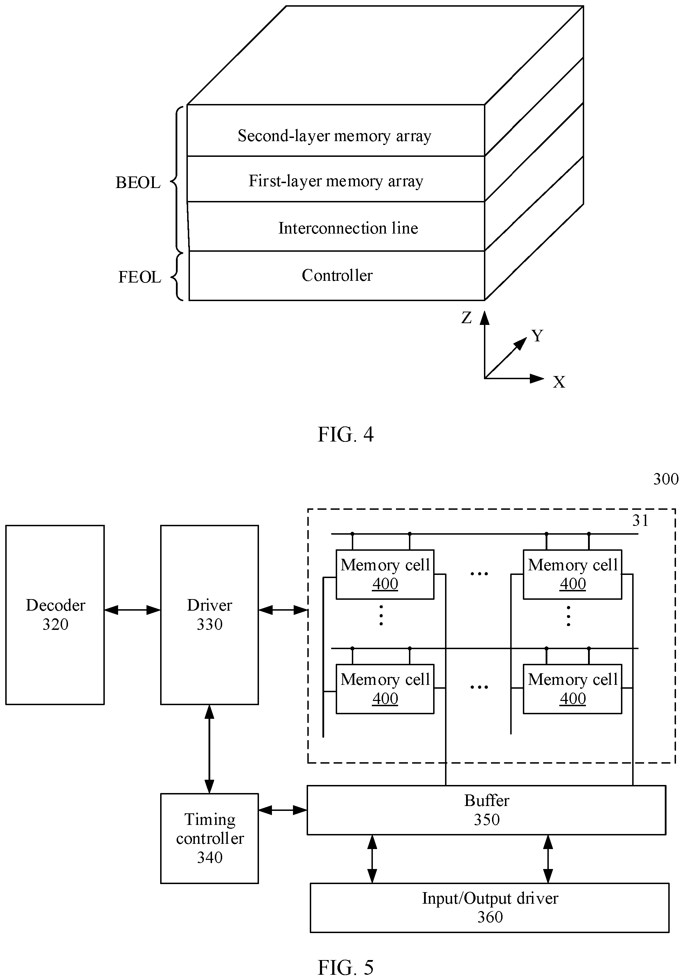

In the structure shown in FIG. 3c, as shown in FIG. 4, the controller 32 may be integrated on a substrate by using a front end of line (front end of line, FEOL) procedure, and an interconnection line and the memory array are integrated on the controller 32 by using a back-end-of-line (back end of line, BEOL) procedure. The controller herein may generate a control signal. The control signal may be a read/write control signal, and is used to control a read/write operation of data in the memory array. In addition, the controller herein may also include an analog circuit part, for example, a sense amplifier.

Further, refer to FIG. 4. The memory array 31 may be one layer of memory array, or may be a first-layer memory array and a second-layer memory array that are stacked in a Z direction perpendicular to the substrate and that are shown in FIG. 4, or may include more layers of memory arrays in some other optional implementations. When two or more layers of memory arrays are included, such a memory may be referred to as a three-dimensional integrated memory structure, to increase storage capacity.

In an implementation, the memory array 31 in the memory may include a plurality of memory cells 400 that are arranged in an array and that are shown in FIG. 5, where each memory cell 400 may be configured to store one bit (bit) or more bits of data. The memory array 31 may further include signal lines such as a word line (word line, WL) and a bit line (bit line, BL). Each memory cell 400 is electrically connected to a corresponding word line WL and a corresponding bit line BL. Different memory cells 400 may be electrically connected to each other through WLs and BLs. One or more of the WLs and the BLs are configured to select a memory cell 400 to be read/written in the memory array by receiving a control level output by a control circuit, to implement a read/write operation of data.

The controller 32 in the memory may include a circuit structure of one or more of a decoder 320, a driver 330, a time sequence controller 340, a buffer 350, or an input/output driver 360 shown in FIG. 5.

In a structure of the memory 300 shown in FIG. 5, the decoder 320 is configured to perform decoding based on a received address, to determine a memory cell 400 to be accessed. The driver 330 is configured to control a level of a signal line based on a decoding result generated by the decoder 320, to implement access to the specified memory cell 400. The buffer 350 is configured to buffer read data, for example, may buffer the data in a first-in first-out (first-in first-out, FIFO) manner. The time sequence controller 340 is configured to control time sequence of the buffer 350, and control the driver 330 to drive the signal line in the memory array 310. The input/output driver 360 is configured to drive a transmission signal, for example, drive a received data signal and drive a data signal to be sent, so that the data signals can be transmitted over a long distance.

The foregoing memory array 310, decoder 320, driver 330, time sequence controller 340, buffer 350, and input/output driver 360 may be integrated into one chip, or may be integrated into a plurality of chips.

The memory 300 in this embodiment of this application may be a dynamic random access memory (dynamic random access memory, DRAM). For example, the memory may be a DRAM including a 2T0C memory cell. A gain-cell memory including a 2T0C memory cell structure can implement a nanosecond-level read/write speed and a millisecond-level storage time, and occupies only one third of an area of a static random access memory (static random access memory, SRAM) because of a wide application scope.

In addition, the memory 300 in this embodiment of this application may also be a ferroelectric random access memory (ferroelectric random access memory, FeRAM). For example, the memory 300 may be an FeRAM including a 2TnC memory cell, where n may be equal to 1 or may be greater than or equal to 2. For example, the memory 300 may be an FeRAM including a 2T1C memory cell or an FeRAM including a 2T2C memory cell.

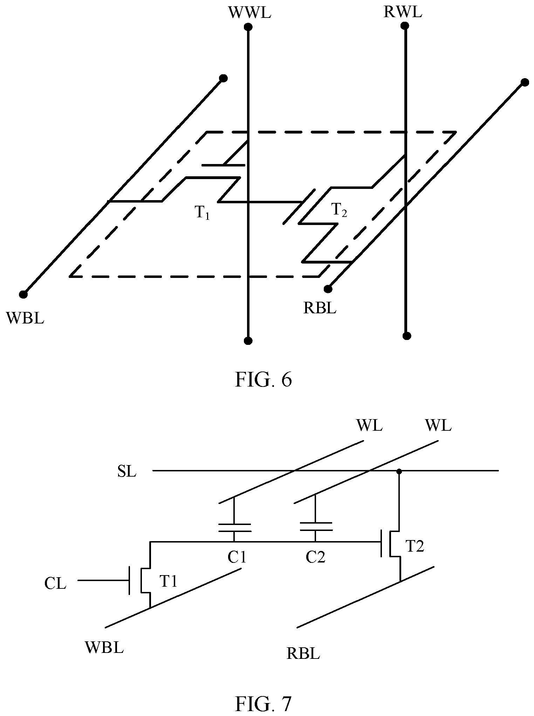

FIG. 6 is a schematic of a circuit of a memory cell 400 in the memory 300 according to an embodiment of this application. As shown in FIG. 6, the memory cell 400 belongs to a 2T0C gain-cell memory cell structure, to be specific, one memory cell 400 includes one write transistor T1 (which may also be referred to as a first transistor T1) and one read transistor T2 (which may also be referred to as a second transistor T2). For example, a thin film transistor (Thin film transistor, TFT) structure may be selected for the first transistor T1 and the second transistor T2.

A first electrode of the write transistor T1 is electrically connected to a write bit line (write bit line, WBL), a second electrode of the write transistor T1 is electrically connected to a gate of the read transistor T2, and a gate of the write transistor T1 is electrically connected to a write word line (write word line, WWL). A first electrode of the read transistor T2 is electrically connected to a read bit line (read bit line, RBL), and a second electrode of the read transistor T2 is electrically connected to a read word line (read word line, RWL).

In the memory cell shown in FIG. 6, the write bit line WBL may also be referred to as a first electrode line configured to load a signal to the first electrode of the write transistor T1, the read bit line RBL may also be referred to as a second electrode line configured to load a signal to the first electrode of the read transistor T2, the write word line WWL may also be referred to as a third electrode line configured to load a signal to the gate of the write transistor T1, and the read word line RWL may also be referred to as a fourth electrode line configured to load a signal to the second electrode of the read transistor T2.

The following separately describes a write operation process and a read operation process of the 2T0C memory cell 400 shown in FIG. 6.

Write operation process: In the write operation process, when a voltage on the read bit line RBL is 0, the read transistor T2 does not operate; and a first write word line control signal is provided for the write word line WWL, and the first write word line control signal controls the write transistor T1 to be turned on. When first logical information is written, for example, "0", a first write bit line control signal is provided for the write bit line WBL (or the read word line RWL), and the first write bit line control signal is written into a node N through the write transistor T1. When second logical information is written, for example, "1", a second write bit line control signal is provided for the write bit line WBL (or the read word line RWL), and the second write bit line control signal is written through the write transistor T1.

It should be understood that, after a write operation is completed, the read transistor T2 does not operate; and a second write word line control signal is provided for the write word line WWL, and the second write word line control signal controls the write transistor T1 to be turned off. In this case, a potential stored in the node is not affected by an external environment.

A read operation process: The second write word line control signal is provided for the write word line WWL, and the second write word line control signal controls the write transistor T1 to be turned off; and a read word line control signal is provided for the read word line RWL (or the write bit line WBL), and logical information stored in the memory cell is determined based on intensity of a current on the read bit line RBL. When the node stores the first write bit line control signal, because the first write bit line control signal may control the read transistor T2 to be turned on, when the read word line control signal is provided for the read word line RWL (or the write bit line WBL), the read word line RWL (or the write bit line WBL) charges the read bit line RBL through the read transistor T2, and the voltage on the read bit line RBL increases. Therefore, when it is detected that the current on the read bit line RBL is large, the logical information "0" stored in the memory cell may be read. When the node stores the second write bit line control signal, because the second write bit line control signal may control the read transistor T2 to be turned off, when the read word line control signal is provided for the read word line RWL (or the write bit line WBL), the read word line RWL (or the write bit line WBL) does not charge the read bit line RBL via the read transistor T2, and the read bit line RBL maintains the voltage at 0 V. Therefore, when it is detected that the current on the read bit line RBL is small, the logical information "1" stored in the memory cell may be read.

FIG. 7 is a schematic of a circuit of another memory cell 400 according to an embodiment of this application. The memory cell 400 includes a first transistor T1, a second transistor T2, a ferroelectric capacitor C1, and a ferroelectric capacitor C2, that is, a 2T2C memory cell. A gate of the first transistor T1 is electrically connected to a pre-charge line CL, a second electrode of the first transistor T1 is electrically connected to a gate of the second transistor T2, a first electrode of the first transistor T1 is electrically connected to a write bit line (write bit line, WBL), a first electrode of the ferroelectric capacitor C1 and a first electrode of the ferroelectric capacitor C2 are electrically connected to a gate of the second transistor T2, a second electrode of the ferroelectric capacitor C1 and a second electrode of the ferroelectric capacitor C2 are electrically connected to word lines WLs respectively, a second electrode of the second transistor T2 is electrically connected to a source line SL, and a first electrode of the second transistor T2 is electrically connected to a read bit line (read bit line, RBL).

In the memory cell shown in FIG. 7, the write bit line WBL may also be referred to as a first electrode line configured to load a signal to the first electrode of the first transistor T1, the read bit line RBL may also be referred to as a second electrode line configured to load a signal to the first electrode of the second transistor T2, the pre-charge line CL may also be referred to as a third electrode line configured to load a signal to the first transistor T1, and the source line SL may also be referred to as a fourth electrode line configured to load a signal to the second electrode of the second transistor T2.

The following separately describes a write operation process and a read operation process of the 2T2C memory cell 400 shown in FIG. 7.

Write operation process: In a write phase, the pre-charge line CL is configured to receive a first pre-charge control signal, to turn on the first transistor T1, the write bit line WBL is configured to receive a first write bit line control signal, the word line WL is configured to receive a first word line control signal, and a voltage difference between the first word line control signal and the first write bit line control signal causes positive polarization or negative polarization of a ferroelectric film layer of the ferroelectric capacitor, to write different logical information into the ferroelectric capacitor. For example, when the positive polarization occurs on the ferroelectric film layer, a logic signal "0" is written. For another example, when the negative polarization occurs on the ferroelectric film layer, a logic signal "1" is written.

Read operation process: If read data is "0", in a first read phase, the pre-charge line CL is configured to receive the first pre-charge control signal, to turn on the first transistor T1, the write bit line WBL is configured to receive a second write bit line control signal, the word line WL is configured to receive a second word line control signal, and a voltage difference between the second word line control signal and the second write bit line control signal causes the ferroelectric film layer of the ferroelectric capacitor to be in a partially-selected state and prevents a polarity of the ferroelectric film layer from being switched, that is, a polarization state remains unchanged; in a second read phase, the pre-charge line CL is configured to receive a second pre-charge control signal, to turn off the first transistor T1, the read bit line RBL is configured to receive a first read bit line control signal, and the word line WL is configured to receive a word line control signal whose voltage is less than that of the second word line control signal, to switch the ferroelectric capacitor from the positive polarization to the negative polarization, and turn off the second transistor T2; and in a third read phase, the pre-charge line CL is configured to receive the first pre-charge control signal, to turn on the first transistor T1, the write bit line WBL is configured to receive the first write bit line control signal, the word line WL is configured to receive the first word line control signal, and the voltage difference between the first word line control signal and the first write bit line control signal causes positive polarization of the ferroelectric film layer of the ferroelectric capacitor. The logic signal "0" is read based on a read bit line potential signal.

If read data is "1", in a first read phase, the pre-charge line CL is configured to receive the first pre-charge control signal, to turn on the first transistor T1, the write bit line WBL is configured to receive a second write bit line control signal, the word line WL is configured to receive a second word line control signal, and a voltage difference between the second word line control signal and the second write bit line control signal causes the ferroelectric film layer of the ferroelectric capacitor to be in a partially-selected state and prevents a polarity of the ferroelectric film layer from being switched, that is, a polarization state remains unchanged; in a second read phase, the pre-charge line CL is configured to receive a second pre-charge control signal, to turn off the first transistor T1, the read bit line RBL is configured to receive a first read bit line control signal, the word line WL is configured to receive a word line control signal whose voltage is less than that of the second word line control signal, to keep a negative polarization state of the ferroelectric capacitor unchanged, and turn on the second transistor T2; and in a third read phase, the pre-charge line CL is configured to receive the first pre-charge control signal, to turn on the first transistor T1, the write bit line WBL is configured to receive the first write bit line control signal, the word line WL is configured to receive the first word line control signal, and the voltage difference between the first word line control signal and the first write bit line control signal causes negative polarization of the ferroelectric film layer of the ferroelectric capacitor. The logic signal "1" is read based on a read bit line potential signal.

In embodiments of this application, for example, the first transistors T1 and the second transistors T2 shown in FIG. 6 and FIG. 7 each may be an NMOS (N-channel metal oxide semiconductor, N-channel metal oxide semiconductor) transistor, or may be a PMOS (P-channel metal oxide semiconductor, P-channel metal oxide semiconductor) transistor.

In addition, in embodiments of this application, one of a drain (drain) or a source (source) of either the first transistor T1 or the second transistor T2 is referred to as a first electrode, correspondingly, the other electrode is referred to as a second electrode, and a control end of the transistor is a gate. A drain and a source of the transistor may be determined based on a flow direction of a current. For example, in the write transistor T1 in FIG. 6, when a current is from left to right, the left end is a drain, and the right end is a source; on the contrary, when a current is from right to left, the right end is a drain, and the left end is a source.

For example, in the memory cells 400 shown in FIG. 6 and FIG. 7, embodiments of this application provide some memory cell process structures that can increase storage density. Details are as follows.

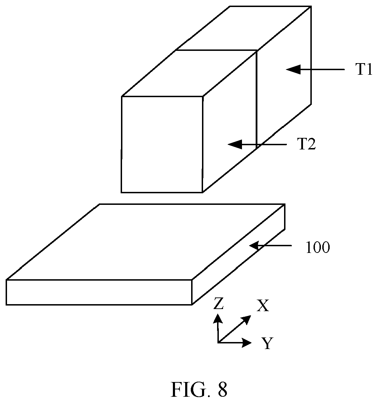

FIG. 8 simply shows an arrangement manner of the first transistor T1 and the second transistor T2 in the memory cell 400. As shown in FIG. 8, the first transistor T1 and the second transistor T2 in any memory cell 400 provided in this embodiment of this application are arranged in a direction parallel to a substrate 100, and are not stacked in a direction perpendicular to the substrate 100.

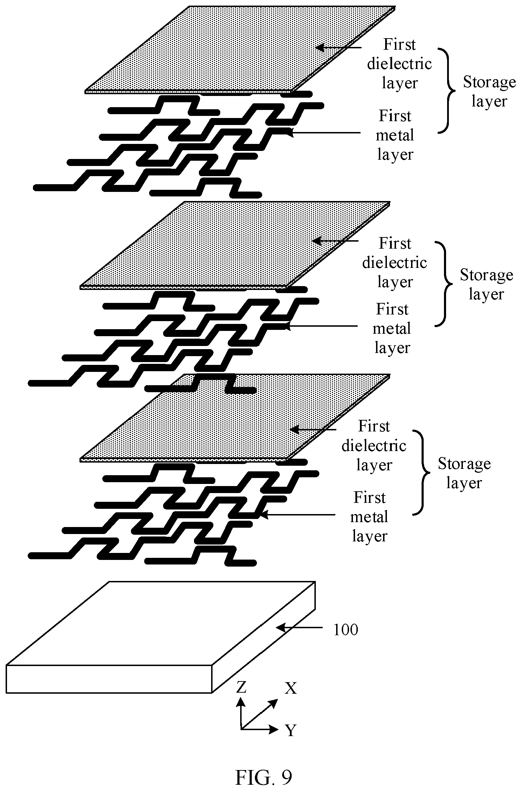

As shown in FIG. 9, a memory array provided in this embodiment of this application includes a plurality of storage layers, and the plurality of storage layers are stacked in the direction perpendicular to the substrate 100. One storage layer shown in FIG. 9 may be understood as one layer of memory array shown in FIG. 4.

Still as shown in FIG. 9, each storage layer includes a first metal layer and a first dielectric layer that are stacked, and the first metal layer and the first dielectric layer are stacked in the direction perpendicular to the substrate 100. Two adjacent first metal layers are electrically isolated from each other through the first dielectric layer.

The first transistor T1 and the second transistor T2 shown in FIG. 8 may be formed in the first metal layer shown in FIG. 9. For a specific arrangement manner that can be implemented, refer to the following.

In addition, in the plurality of storage layers that are formed on the substrate and that are stacked in the direction perpendicular to the substrate, in one storage layer closest to the substrate, all layer structures (for example, an electrode and a channel) in the storage layer may be located on a surface of the substrate; or one part of the layer structures (for example, an electrode) may be located in the storage layer, and the other part of the layer structures (for example, a channel) may be located at a position that is of the substrate and that is close to a surface.

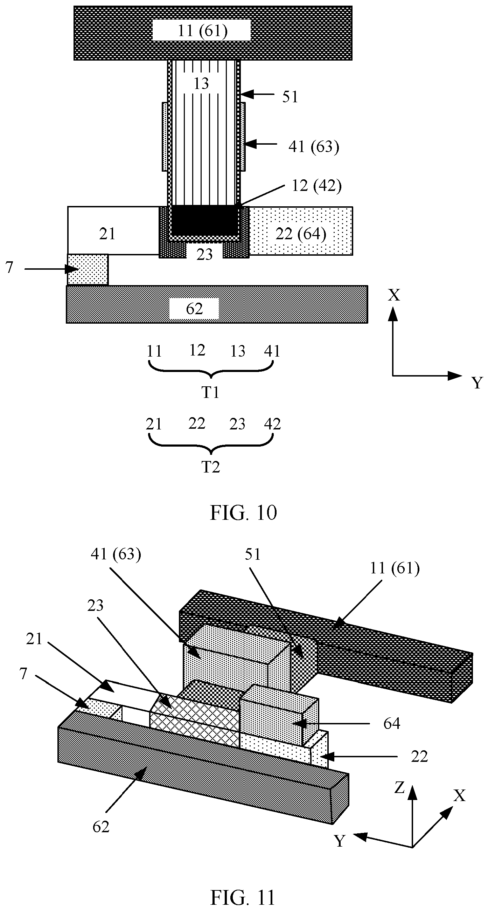

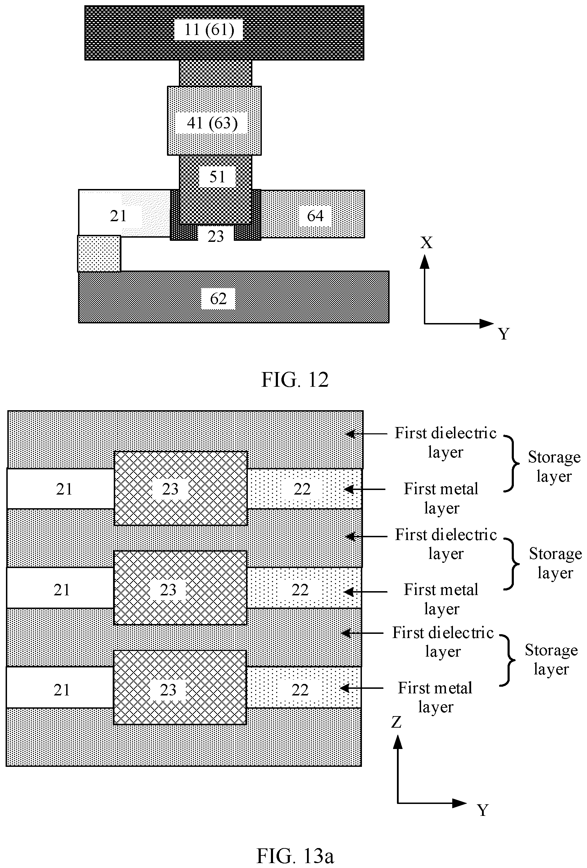

FIG. 10 is a sectional view of an implementable process structure of the first transistor T1 and the second transistor T2 according to an embodiment of this application, FIG. 11 is a three-dimensional view of FIG. 10, and FIG. 12 is a top view of FIG. 11.

With reference to FIG. 10, FIG. 11, and FIG. 12, in this embodiment, a first electrode 11 and a second electrode 12 of the first transistor T1 and a first electrode 21 and a second electrode 22 of the second transistor T2 are located in the first metal layer that is parallel to the substrate and that is shown in FIG. 9. To be specific, it may be understood that, in a technical process, in a structure of a film layer (for example, a semiconductor layer) parallel to the substrate, patterning may be performed to form the first electrode 11 and the second electrode 12 of the first transistor T1 and the first electrode 21 and the second electrode 22 of the second transistor T2, so that the first electrode 11 and the second electrode 12, and the first electrode 21 and the second electrode 22 are located in the first metal layer parallel to the substrate, instead of being stacked in the direction perpendicular to the substrate. The following describes, with reference to a manufacturing technical process, how to manufacture the first electrode 11 and the second electrode 12 of the first transistor T1 and the first electrode 21 and the second electrode 22 of the second transistor T2 on a same film layer.

Still as shown in FIG. 10, a first electrode line 61 electrically connected to the first electrode 11 of the first transistor T1, a second electrode line 62 electrically connected to the first electrode 21 of the second transistor T2, the first electrode 11 and the second electrode 12 of the first transistor T1, and the first electrode 21 and the second electrode 22 of the second transistor T2 are located in the first metal layer shown in FIG. 9.

In addition, the first electrode line 61 and the second electrode line 62 extend in a same direction. For example, as shown in FIG. 10, the first electrode line 61 and the second electrode line 62 extend in a Y direction parallel to the substrate.

Still as shown in FIG. 10, at least a part of a channel layer 13 of the first transistor T1 and at least a part of a channel layer 23 of the second transistor T2 are also located in the metal layer in which the first electrode line 61 and the second electrode line 62 are located.

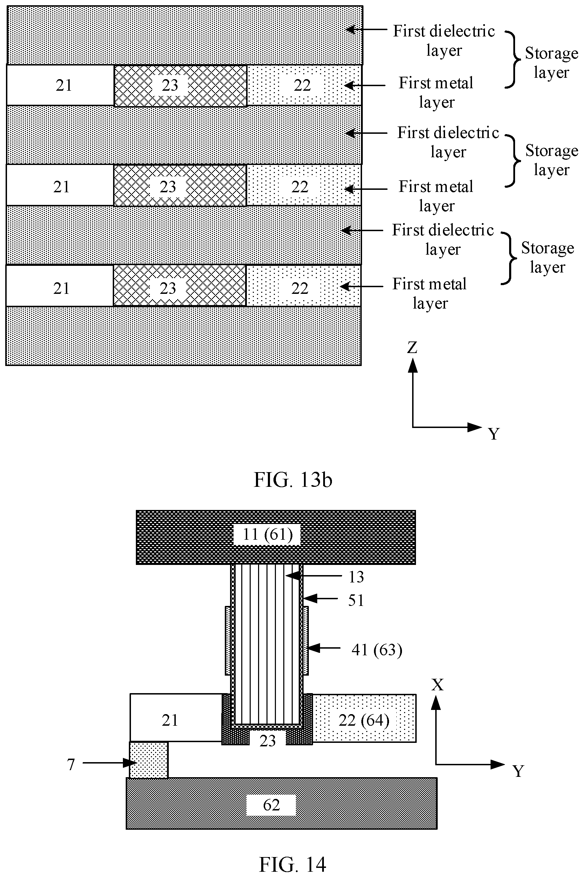

In conclusion, the first electrode line 61, the second electrode line 62, and the first electrode, the second electrode, and at least a part of the channel layer of either the first transistor T1 or the second transistor T2 are located in the same metal layer. "At least a part of the channel layer of either the first transistor T1 or the second transistor T2 is located in the first metal layer" in this embodiment of this application may be understood as that, as shown in FIG. 13a and FIG. 13b, the channel layer 23 of the second transistor T2 is used as an example for description in FIG. 13a and FIG. 13b; and in FIG. 13a, in the second transistor T2, the first electrode 21 and the second electrode 22 are located in the first metal layer, one part of the channel layer 23 electrically connected to the first electrode 21 and the second electrode 22 is located in the first metal layer, and the other part of the channel layer 23 extends to a first dielectric layer adjacent to the first metal layer; however, in FIG. 13b, in the second transistor T2, the first electrode 21 and the second electrode 22 are located in the first metal layer, and the channel layer 23 electrically connected to the first electrode 21 and the second electrode 22 is totally located in the first metal layer and does not extend to a first dielectric layer.

A manner of disposing the channel layer of the first transistor T1 is similar to a manner of disposing the channel layer of the second transistor T2 shown in FIG. 13a and FIG. 13b. For example, the channel layer of the first transistor T1 may be totally located in the first metal layer, or may be partially located in the first metal layer and partially located in the first dielectric layer.

In the structure shown in FIG. 10, the second electrode 12 may not only serve as the second electrode of the first transistor T1, but also serve as a gate 42 of the second transistor T2, that is, the second electrode of the first transistor T1 shares a same electrode with the gate of the second transistor T2.

Further, still as shown in FIG. 10, the first electrode 11 of the first transistor T1 may share a same electrode line with the first electrode line 61.

In some embodiments, in FIG. 10 to FIG. 12, the first electrode line 61 may be the write bit line WBL in the 2T0C memory cell shown in FIG. 6, and the second electrode line 62 may be the read bit line RBL in the 2T0C memory cell shown in FIG. 6. In some other embodiments, in FIG. 10 to FIG. 12, the first electrode line 61 may be the write bit line WBL in the 2T2C memory cell shown in FIG. 7, and the second electrode line 62 may be the read bit line RBL in the 2T2C memory cell shown in FIG. 7.

For a manner of disposing a third electrode line 63 and a fourth electrode line 64, as shown in FIG. 11, both the third electrode line 63 and the fourth electrode line 64 extend in the direction perpendicular to the substrate. For example, both the write word line WWL and the read word line RWL in the 2T0C memory cell shown in FIG. 6 extend in the Z direction perpendicular to the substrate.

It can be learned from the foregoing description that, the memory cell including the first transistor T1 and the second transistor T2 in embodiments of this application may be arranged in the direction parallel to the substrate and in the direction perpendicular to the substrate, so that three-dimensional stacking can be implemented. This can implement high-density integration, and can increase storage capacity of the memory array.

In addition, in each memory cell, the first electrode, the second electrode, and the channel layer of each of the first transistor T1 and the second transistor T2, the first electrode line 61, and the second electrode line 62 are formed in a same metal layer, instead of being stacked into two layers or more layers in the direction perpendicular to the substrate.

From a perspective of a process method, a plurality of memory cells that are stacked in the direction perpendicular to the substrate may be simultaneously manufactured on a plurality of stacked semiconductor layers, or multiple layers of memory arrays may be simultaneously manufactured, instead of manufacturing one layer of memory array and then manufacturing another layer of memory array, so that when the memory array provided in embodiments of this application is manufactured, a manufacturing technical process can be simplified, and process complexity may be reduced. A specific process method that can be implemented is described subsequently, and how to simultaneously manufacture multiple layers of components through a one-time process is described with reference to the process method. Details are not described herein.

Still as shown in FIG. 10, the channel layer 13 of the first transistor T1 and the channel layer 23 of the second transistor T2 are arranged perpendicularly to each other. For example, the channel layer 13 in an X-Y plane extends in the X direction, and the channel layer 23 extends in the Y direction perpendicular to the X direction.

That is, a current direction in the channel layer 13 of the first transistor T1 is perpendicular to a current direction in the channel layer 23 of the second transistor T2.

FIG. 14 is another implementable structure of the first transistor T1 and the second transistor T2 according to an embodiment of this application. Through comparison between FIG. 14 and FIG. 10, in the embodiment shown in FIG. 14, the second electrode 12 or the gate 42 is omitted. The channel layer 13 of the first transistor T1 is electrically isolated from the channel layer 23 of the second transistor T2 through a gate dielectric layer 51. Further, in this embodiment, the channel layer 13 may not only serve as a channel of the first transistor T1, but also serve as the gate 42 of the second transistor T2 or the second electrode 12 of the first transistor. Therefore, storage density can also be increased by simplifying a process structure.

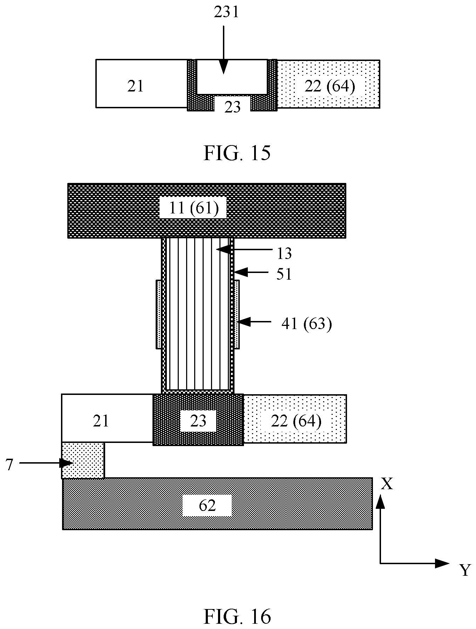

To further reduce an area occupied by the memory cell and further increase the storage density, as shown in FIG. 14 and FIG. 15, a concave cavity 231 may be formed at a position that is of the channel layer 23 and that is close to the channel layer 13, and one end of the channel layer 13 extends into the concave cavity 231. In this design, a size of the memory cell in the X direction can be reduced, so that integration density of the memory cell can be increased. In other words, in the X-Y plane, more memory cells may be integrated in a direction parallel to the channel layer 13.

For example, as shown in FIG. 10, the gate dielectric layer 51 may be formed on a wall surface of the concave cavity 231, and the second electrode 12 extending into the concave cavity 231 is electrically isolated from the channel layer 13 through the gate dielectric layer 51 located in the concave cavity 231. For another example, as shown in FIG. 14, the one end of the channel layer 13 extends into the concave cavity 231, and is electrically isolated from the channel layer 13 through the gate dielectric layer 51 located in the concave cavity 231.

In some other implementable structures, FIG. 16 shows an example of another implementable structure of the memory cell. As shown in FIG. 16, no concave cavity is formed at a position that is of the channel layer 23 and that is close to the channel layer 13, and a surface that is of the channel layer 23 and that faces the channel layer 13 is a plane. In addition, the channel layer 13 is electrically isolated from the channel layer 23 through the gate dielectric layer 51 formed on the plane.

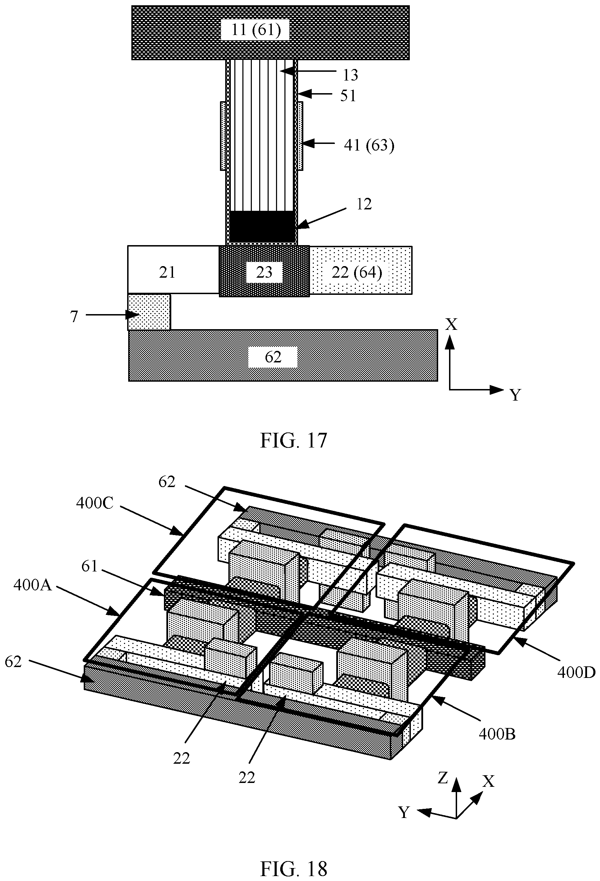

Alternatively, as shown in FIG. 17, similar to that in FIG. 15, a surface that is of the channel layer 23 and that faces the channel layer 13 is a plane, the second electrode 12 of the first transistor T2 is formed at an end part of the channel layer 13, and the second electrode 12 is electrically isolated from the channel layer 23 through the gate dielectric layer 5.

Still as shown in FIG. 10 to FIG. 17, the first transistor T1 further includes a gate 41. The gate 41 of the first transistor T1 may be of a single-gate structure, or may be of a double-gate structure, or may be a gate-all-around structure shown in FIG. 12.

In some structures, as shown in FIG. 16 and FIG. 17, the gate 41 of the first transistor T1 is electrically isolated from the channel layer 13 through the gate dielectric layer 51. The gate 41 of the first transistor T1 and the third electrode line 63 may belong to a same metal layer, that is, the third electrode line 63 is electrically isolated from the channel layer 13 through the gate dielectric layer 51.

With reference to FIG. 17 again, in the first transistor T1, the first electrode 11 is formed at an end that is of the channel layer 13 and that is away from the channel layer 23; and in the second transistor T2, the first electrode 21 is formed at one of two opposite ends of the channel layer 23, and the second electrode 22 is formed at the other end.

The first electrode line 61 (for example, the write bit line WBL) and the second electrode line 62 (for example, the read bit line RBL) are further formed in a metal layer in which the first electrode 11, the second electrode 12, and the channel layer 13 of the first transistor T1 and the first electrode 21, the second electrode 22, and the channel layer 23 of the second transistor T2 are located. The first electrode line 61 and the second electrode line 62 extend in a same direction. For example, the first electrode line 61 and the second electrode line 62 may extend in the Y direction parallel to the substrate.

In an optional process structure, as shown in FIG. 17, the first electrode 11 of the first transistor T1 shares a same metal layer with the first electrode line 61, that is, the first electrode line 61 may be in direct contact with the channel layer 13 shown in FIG. 17, to implement an electrical connection.

Still as shown in FIG. 17, the fourth electrode line 64 extending in the direction perpendicular to the substrate may share a same metal layer with the second electrode of the second transistor T2, that is, the fourth electrode line 64 may be in direct contact with the channel layer 23, to implement an electrical connection between the second transistor T2 and the fourth electrode line 64.

Still as shown in FIG. 17, the second electrode line 62 extends in the Y direction, and the second electrode line 62 is located on a side that is of the channel layer 23 and that is away from the first transistor T1. To electrically connect the first electrode 21 of the second transistor T2 to the second electrode line 62, as shown in FIG. 17, the memory cell further includes a conductive connection portion 7, and the first electrode 21 of the second transistor T2 is electrically connected to the second electrode line 62 through the conductive connection portion 7.

In some embodiments, as shown in FIG. 17, the first electrode line 61, the first electrode 21 and the second electrode 22 of the second transistor T2, the conductive connection portion 7, and the second electrode line 62 may located in the metal layer. Alternatively, in some other embodiments, some of the first electrode line 61, the first electrode 21 and the second electrode 22 of the second transistor T2, the conductive connection portion 7, and the second electrode line 62 located in the metal layer, and some of the first electrode line 61, the first electrode 21 and the second electrode 22 of the second transistor T2, the conductive connection portion 7, and the second electrode line 62 located in a conductive layer formed in a semiconductor material through a doping process. For example, in FIG. 17, the first electrode line 61 and the second electrode 22 located in the metal layer, and the first electrode 21 of the second transistor T2, the conductive connection portion 7, and the second electrode line 62 located in a conductive layer formed in a semiconductor material through a doping process. How to form the conductive layer in the semiconductor material through the doping process is described below in a method for manufacturing a memory array.

As shown in FIG. 18, FIG. 18 shows that four memory cells shown above are included. The four memory cells form a 2×2 memory array. The four memory cells in the 2×2 memory array are referred to as a memory cell 400A, a memory cell 400B, a memory cell 400C, and a memory cell 400D respectively.

The memory cell 400A and the memory cell 400B are arranged in the Y direction parallel to the substrate, and the memory cell 400A and the memory cell 400B are mirror-symmetrically arranged in the X direction parallel to the substrate. It may be understood that a second electrode 22 of a second transistor T2 in the memory cell 400A is disposed close to a second electrode 22 of a second transistor T2 in the memory cell 400B. The second electrode 22 of the second transistor T2 in the memory cell 400A is electrically isolated from the second electrode 22 of the second transistor T2 in the memory cell 400B through an insulation layer.

In addition, a second electrode line 62 extends in the Y direction, and the memory cell 400A and the memory cell 400B that are arranged in the Y direction are electrically connected to a same second electrode line 62.

Refer to FIG. 18 again. The memory cell 400A and the memory cell 400C are arranged in the X direction parallel to the substrate, and the memory cell 400A and the memory cell 400C are mirror-symmetrically arranged in the Y direction parallel to the substrate. In addition, a channel layer of a first transistor T1 in the memory cell 400A and a channel layer of a first transistor T1 in the memory cell 400C are electrically connected to a same first electrode line 61, that is, share the same first electrode line 61.

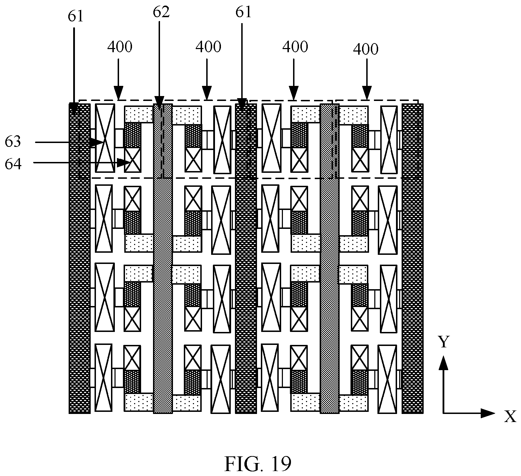

If the structure shown in FIG. 18 is arranged in the X-Y plane parallel to the substrate, one layer of memory array shown in FIG. 19 may be obtained. FIG. 19 also shows an example of a part of the layer of memory array.

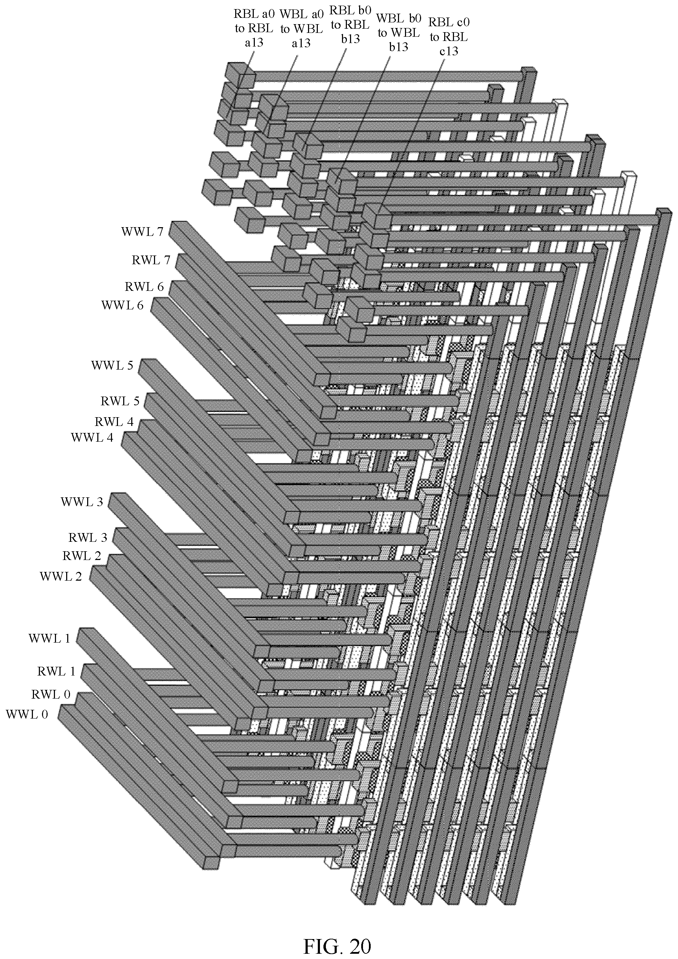

If the structure shown in FIG. 19 is arranged in the Z direction perpendicular to the substrate, a three-dimensional memory array shown in FIG. 20 may be obtained. The memory array shown in FIG. 20 may be electrically connected to a controller through an interconnection line. For example, as shown in FIG. 20, the interconnection line may be formed on a side that is of the memory array and that is away from the substrate through a back-end-of-line process.

Still as shown in FIG. 20, the interconnection line that is formed on the substrate and that is electrically connected to the memory array includes a plurality of write word line interconnection lines that are laid in parallel, for example, a WWL 0, a WWL 1, a WWL 2, a WWL 3, a WWL 4, a WWL 5, a WWL 6, and a WWL 7 shown in FIG. 20, and any WWL may be connected to a write word line in the X-Y plane through a conductive channel. In addition, the interconnection line further includes a plurality of read word line interconnection lines that are laid in parallel, for example, an RWL 0, an RWL 1, an RWL 2, an RWL 3, an RWL 4, an RWL 5, and an RWL 6 shown in FIG. 20, and any RWL may be connected to a read word line in the X-Y plane through a conductive channel.

In addition, the interconnection line further includes a plurality of read bit line interconnection lines shown in FIG. 20, for example, an RBL c0 to an RBL c13 shown in FIG. 20. Each read bit line interconnection line is connected to a read bit line in the X-Y plane through a conductive channel. In addition, the interconnection line further includes a plurality of write bit line interconnection lines shown in FIG. 20, for example, a WBL c0 to a WBL c13 shown in FIG. 20. Each write bit line interconnection line is connected to a write bit line in the X-Y plane through a conductive channel.

When a read/write operation is performed, a to-be-read memory cell may be selected through these interconnection lines shown in FIG. 20. The specific read/write process has been described above. Details are not described herein again.

In the memory cell provided in the foregoing embodiment, the first transistor T1, the second transistor T2, the first electrode line 61, the second electrode line 62, the third electrode line 63, and the fourth electrode line 64 may be made of a plurality of materials. The following provides some of available materials.

In the available materials, either the channel layer 13 or the channel layer 23 may be made of one or more of semiconductor materials such as Si (silicon), poly-Si (p-Si, polycrystalline silicon), amorphous-Si (a-Si, amorphous silicon), an In-Ga-Zn-O (IGZO, indium gallium zinc oxide) poly-compound, ZnO (zinc oxide), ITO (indium tin oxide), TiO2 (titanium dioxide), MoS2 (molybdenum disulfide), WS2 (tungsten disulfide), graphene, and black phosphorus.

The gate dielectric layer 51 may be made of one or more of insulation materials such as SiO2 (silicon dioxide), Al2O3 (aluminum oxide), HfO2 (hafnium dioxide), ZrO2 (zirconia), TiO2 (titanium dioxide), Y2O3 (yttrium oxide), and Si3N4 (silicon nitride).

The first electrode and the second electrode of either the first transistor T1 or the second transistor T2, the first electrode line, the second electrode line, the third electrode line, and the fourth electrode line each are made of a conductive material, for example, a metal material. In an optional implementation, the first electrode 11/21 and the second electrode 12/22 may be made of one or more of conductive materials such as TiN (titanium nitride), Ti (titanium), Au (aurum), W (tungsten), Mo (molybdenum), In-Ti-O (ITO, indium tin oxide), Al (aluminum), Cu (cuprum), Ru (ruthenium), and Ag (argentum).

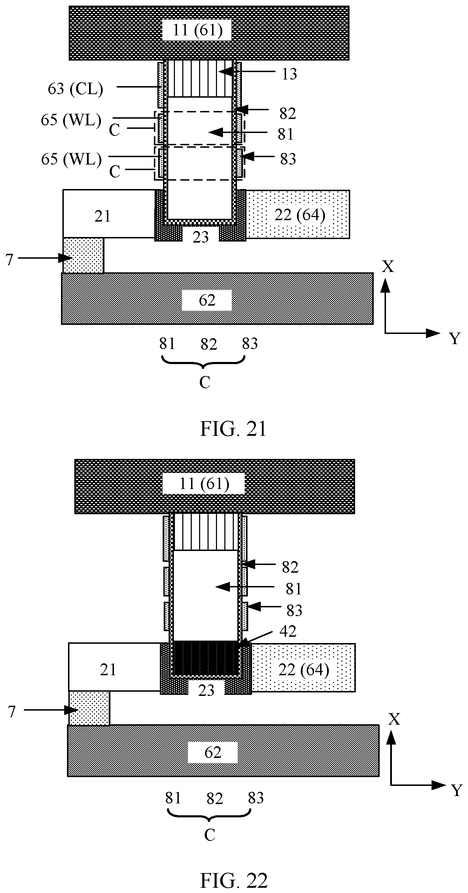

The diagram of the process structure of the 2T0C memory cell including the first transistor T1 and the second transistor T2 is provided above. In addition, an embodiment of this application further provides a diagram of a process structure of a 2TnC memory cell including a first transistor T1 and a second transistor T2. For example, FIG. 21 shows a diagram of an example of a process structure of a 2T2C memory cell. For example, the 2T2C memory cell may be used in an FeRAM memory array.

Refer to FIG. 21. Similar to the 2T0C memory cell, the 2TnC memory cell provided in this embodiment of this application includes the first transistor T1 and the second transistor T2. A difference lies in that the 2TnC memory cell further includes a ferroelectric capacitor C. In some embodiments, one ferroelectric capacitor C may be included, or two ferroelectric capacitors C are included in FIG. 21, or more ferroelectric capacitors C are included.

In terms of a process structure, the 2TnC memory cell shown in FIG. 21 is the same as the 2T0C memory cell shown above. A first electrode 11, a second electrode 12, and a channel layer 13 of the first transistor T1, a first electrode 21, a second electrode 22, and a channel layer 23 of the second transistor T2, a first electrode line 61, and a second electrode line 62 are located in a same metal layer parallel to a substrate, the first electrode line 61 and the second electrode line 62 extend in a same direction, and a third electrode line 63 and a fourth electrode line 64 extend in a direction perpendicular to the substrate.

In terms of a process method for manufacturing the process structure shown in FIG. 21, similar to the 2T0C memory cell, the 2TnC memory cell may use a one-time process, and a plurality of memory cells stacked in the direction perpendicular to the substrate are manufactured at the same time. This can simplify a manufacturing technical process, and reduce process complexity.

With reference to the process structure of the 2TnC memory cell shown in FIG. 21 and the circuit structure of the 2TnC memory cell shown in FIG. 7, it can be learned that the first electrode line 61 in FIG. 21 is the write bit line WBL shown in FIG. 7, the second electrode line 62 is the read bit line RBL shown in FIG. 7, the third electrode line 63 is the source line SL shown in FIG. 7, and the fourth electrode line 64 is the pre-charge line CL shown in FIG. 7.

For an arrangement manner of the channel layer 13 of the first transistor T1 and the channel layer 23 of the second transistor T2, an extension direction of the first electrode line 61, and an extension direction of the second electrode line 62 shown in FIG. 21, refer to the 2T0C memory cell. For example, as shown in FIG. 21, the channel layer 13 of the first transistor T1 and the channel layer 23 of the second transistor T2 are arranged perpendicularly to each other, and the extension direction of the first electrode line 61 and the extension direction of the second electrode line 62 are consistent with an extension direction of the channel layer 23.

Still as shown in FIG. 21, the ferroelectric capacitor C of the 2TnC memory cell includes a first ferroelectric electrode 81, a ferroelectric film layer 82, and a second ferroelectric electrode 83, where the ferroelectric film layer 82 is stacked between the first ferroelectric electrode 81 and the second ferroelectric electrode 83.

As shown in FIG. 21, the first ferroelectric electrode 81 is also located in the metal layer in which the first electrodes and the second electrodes of the first transistor T1 and the second transistor T2 are located. That is, the first electrode 11, the first electrode 21
, the second electrode 22, at least a part of the channel layer 13, at least a part of the channel layer 23, and the first ferroelectric electrode 81 in FIG. 21 are all located in the same metal layer.

Refer to FIG. 21. A concave cavity 231 is formed at a position that is on the channel layer 23 of the second transistor T2 and that is close to the first transistor T1, the first ferroelectric electrode 81 is formed at an end part of the channel layer 13 of the first transistor T1, a part of the first ferroelectric electrode 81 extends into the concave cavity 231, and the first ferroelectric electrode 81 is electrically isolated from the channel layer 23 through the ferroelectric film layer 82. The first ferroelectric electrode 81 may not only serve as a first electrode of the ferroelectric capacitor, but also serve as a gate of the second transistor, or may also serve as an electrode of the first transistor.

Still as shown in FIG. 21, the second ferroelectric electrode 83 may be electrically connected to a fifth electrode line 65, for example, electrically connected to the word line WL shown in FIG. 7. The first ferroelectric electrode serves as an electrode of the ferroelectric capacitor, to complete writing of stored information via a voltage difference between the first ferroelectric electrode and the word line WL.

In this embodiment, both the pre-charge line CL and the word line WL extend in the direction perpendicular to the substrate. For example, in the 2T2C memory cell shown in FIG. 21, two word lines WLs and a pre-charge line CL are parallel to each other, and are arranged in the direction perpendicular to the substrate. In addition, the word line WL is electrically isolated from the pre-charge line CL, and the word lines WLs are also electrically isolated from each other.

FIG. 22 is a diagram of a process structure of another 2TnC memory cell according to an embodiment of this application. In this embodiment, not only a first ferroelectric electrode 81 is shown, but also a gate 42 of a second transistor T2 is shown, where the gate 42 is in contact with and electrically connected to the first ferroelectric electrode 81, and at least a part of the gate 42 is embedded into a concave cavity 231 of a channel layer 23.

In the 2TnC memory cell shown in FIG. 21 and FIG. 22, the first ferroelectric electrode 81 may be made of at least one of tungsten W, titanium nitride TiN, polycrystalline silicon, cobalt Co, nickel Ni, and cuprum Cu, and the gate 42 may also be made of at least one of tungsten W, titanium nitride TiN, polycrystalline silicon, cobalt Co, nickel Ni, and cuprum Cu. When the first ferroelectric electrode 81 and the gate 42 are made of a same material, the structure, in which the first ferroelectric electrode 81 and the gate 42 are integrated, shown in FIG. 21 may be formed. Otherwise, when the first ferroelectric electrode 81 and the gate 42 are made of different materials, the structure shown in FIG. 22 may be formed.

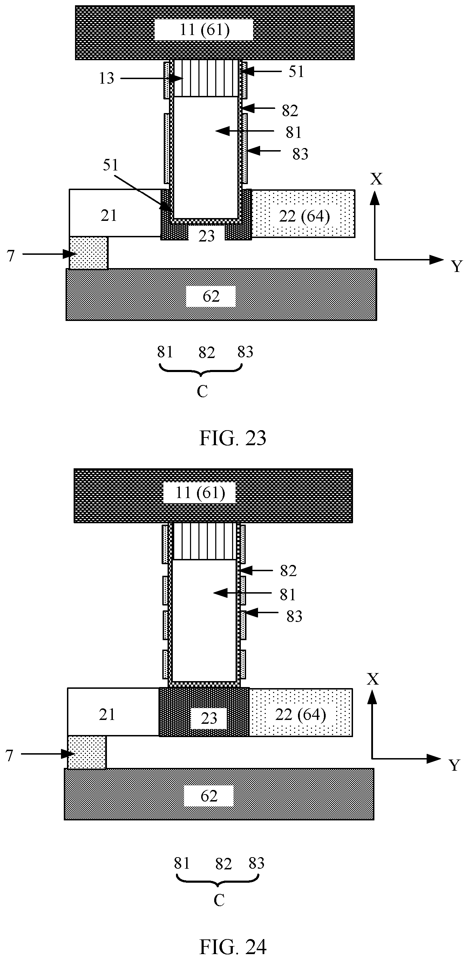

FIG. 23 is a diagram of a process structure of another 2TnC memory cell according to an embodiment of this application. Compared with that in FIG. 21 and FIG. 22, the memory cell with this structure includes only one ferroelectric capacitor C, and other structures are similar. Through comparison between FIG. 23 and FIG. 22, when the 2TnC memory cell includes a plurality of ferroelectric capacitors C, the plurality of ferroelectric capacitors C are spaced from each other, and an arrangement direction is consistent with an extension direction of a channel layer 13 of a first transistor T1. A plurality of second ferroelectric electrodes 83 included in the plurality of ferroelectric capacitors C are insulated from each other. For example, two adjacent second ferroelectric electrodes 83 may be electrically isolated from each other through an insulation layer.

With reference to FIG. 21 and FIG. 22, the ferroelectric film layer 82 that electrically isolates the first ferroelectric electrode 81 from the second ferroelectric electrode 83 may be integrated with the gate dielectric layer 51 that electrically isolates the first ferroelectric electrode 81 from the channel layer 23. For example, one or more of ferroelectric materials such as ZrO2 (zirconia), HfO2 (hafnium dioxide), Al-doped HfO2, Si-doped HfO2, Zr-doped HfO2, La-doped HfO2, and Y-doped HfO2, or a material formed by doping another element into the material may be selected.

With further reference to FIG. 21 and FIG. 22, the ferroelectric film layer 82 that electrically isolates the first ferroelectric electrode 81 from the second ferroelectric electrode 83 may be integrated with the gate dielectric layer 51 that electrically isolates the channel layer 13 from the first electrode line 61.

In some optional embodiments, to simplify a manufacturing process, as shown in FIG. 23, the ferroelectric film layer 82 that electrically isolates the first ferroelectric electrode 81 from the second ferroelectric electrode 83, the gate dielectric layer 51 that electrically isolates the second ferroelectric electrode 83 from the channel layer 23, and the gate dielectric layer 51 that electrically isolates the channel layer 13 from the first electrode line 61 may be integrated. For example, one or more of ferroelectric materials such as ZrO2 (zirconia), HfO2 (hafnium dioxide), Al-doped HfO2, Si-doped HfO2, Zr-doped HfO2, La-doped HfO2, and Y-doped HfO2, or a material formed by doping another element into the material may be selected.

With reference to FIG. 21, FIG. 22, and FIG. 23, the concave cavity 231 is formed on the channel layer 23, and at least a part of the first ferroelectric electrode 81 or at least a part of the gate 42 is embedded into the concave cavity 231. This can further reduce a size of the memory cell, and increase integration density of the 2TnC memory cell.

FIG. 24 is a diagram of a process structure of another 2TnC memory cell according to an embodiment of this application. In the memory cell, no concave cavity is formed on a side surface of a channel layer 23, that is, a surface that is of the channel layer 23 and that faces a first ferroelectric electrode 81 is a plane, and the first ferroelectric electrode 81 is electrically isolated from the channel layer 23 through a ferroelectric film layer 82.

In the 2TnC memory cell shown in FIG. 21 to FIG. 24, for an available material of another structure, refer to a material of a corresponding structure in the 2T0C memory cell.

In some implementable structures, any memory cell in FIG. 21 to FIG. 24 is arranged in the X direction, the Y direction, and the Z direction that are perpendicular to each other, to obtain a three-dimensional memory array.

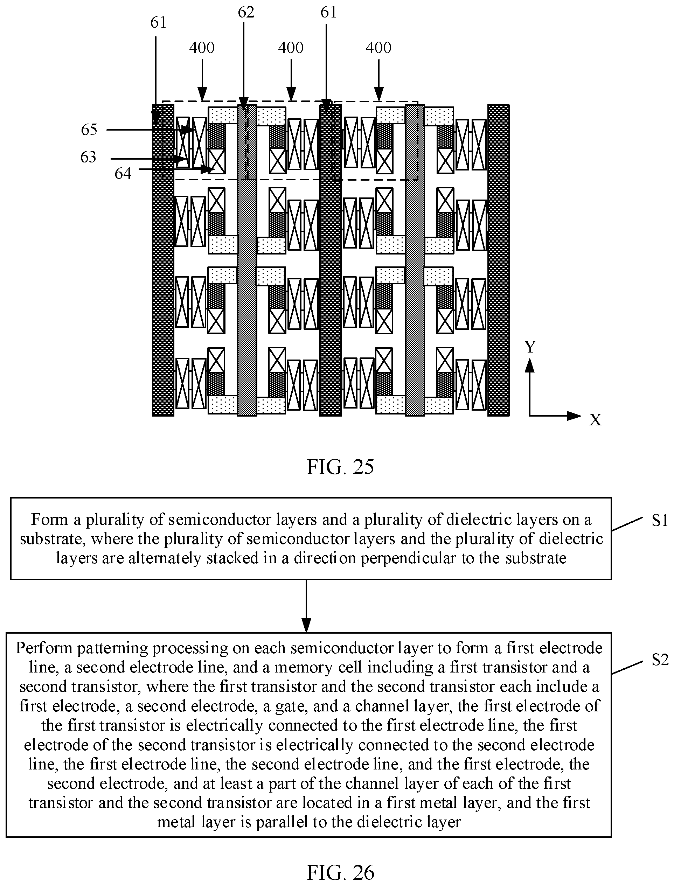

FIG. 25 simply shows an example of a memory array formed in an X-Y plane when the 2TnC memory cell shown in FIG. 21 is used. The first electrode line 61 and the second electrode line 62 extend in a same direction, for example, extend in the Y direction parallel to the substrate; and the third electrode line 63, the fourth electrode line 64, and the fifth electrode line 65 extend in the direction perpendicular to the substrate. For example, the first electrode line 61 is a WBL, the second electrode line 62 is an RBL, the third electrode line is a CL, the fourth electrode line is an SL, and the fifth electrode line is a WL.

In addition, an embodiment of this application further provides a method for forming a memory array. FIG. 26 is a block diagram of an example of a procedure for manufacturing a memory array.

Step S1: Form a plurality of semiconductor layers and a plurality of dielectric layers on a substrate, where the plurality of semiconductor layers and the plurality of dielectric layers are alternately stacked in a direction perpendicular to the substrate.

For example, when five layers of memory cells need to be manufactured, five semiconductor layers and five dielectric layers may be stacked on the substrate, and the five semiconductor layers and the five dielectric layers are alternately stacked, in other words, two adjacent semiconductor layers are isolated from each other through one dielectric layer.

The semiconductor layer herein may be made of one or more of semiconductor materials such as Si (silicon), poly-Si (p-Si, polycrystalline silicon), amorphous-Si (a-Si, amorphous silicon), an In-Ga-Zn-O (IGZO, indium gallium zinc oxide) poly-compound, ZnO (zinc oxide), ITO (indium tin oxide), TiO2 (titanium dioxide), MoS2 (molybdenum disulfide), and WS2 (tungsten disulfide).

The dielectric layer may be made of one or more of insulation materials such as SiO2 (silicon dioxide), Al2O3 (aluminum oxide), HfO2 (hafnium dioxide), ZrO2 (zirconia), TiO2 (titanium dioxide), Y2O3 (yttrium oxide), and Si3N4 (silicon nitride).

Step S2: Perform patterning processing on each semiconductor layer to form a first electrode line, a second electrode line, and a memory cell including a first transistor and a second transistor. The first transistor and the second transistor each include a first electrode, a second electrode, a gate, and a channel layer. The first electrode of the first transistor is electrically connected to the first electrode line, the first electrode of the second transistor is electrically connected to the second electrode line, the first electrode line, the second electrode line, and the first electrode, the second electrode, and at least a part of the channel layer of each of the first transistor and the second transistor are located in a first metal layer, and the first metal layer is parallel to the dielectric layer.

When step S2 is performed, a sequence of manufacturing the first electrode line, the second electrode line, the first transistor, and the second transistor is not limited in embodiments of this application. For example, the first transistor and the first electrode line may be first manufactured, and then the second transistor and the second electrode line are manufactured.

The first transistor and the second transistor each include the first electrode, the second electrode, the gate, and the channel layer. The first electrode of the first transistor is electrically connected to the first electrode line, and the first electrode of the second transistor is electrically connected to the second electrode line.

In addition, the gate of the first transistor is electrically connected to a third electrode line, and the second electrode of the second transistor is electrically connected to a fourth electrode line.

In addition, the first electrode line, the second electrode line, and the first electrode, the second electrode, and the channel layer of each of the first transistor and the second transistor are located in a same metal layer parallel to the substrate. In other words, patterning processing may be performed on a same semiconductor layer, to manufacture the first electrode, the second electrode, the channel layer, the first electrode line, and the second electrode line.

The following describes specific technical processes involved in step S1 and step S2 with reference to accompanying drawings.

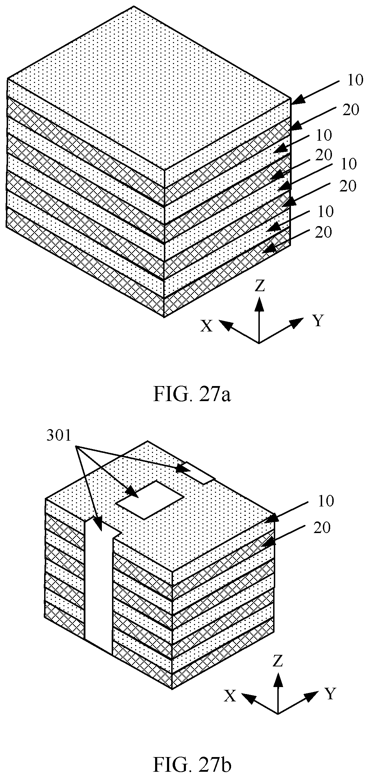

FIG. 27a to FIG. 27l each show a process structure obtained after each step in a technical process of manufacturing a memory array according to an embodiment of this application is completed.

As shown in FIG. 27a, a plurality of semiconductor layers 10 and a plurality of dielectric layers 20 are formed on a substrate (not shown in the figure), and the plurality of semiconductor layers 10 and the plurality of dielectric layers 20 are alternately stacked in a direction perpendicular to the substrate. Available materials for the semiconductor layer and the dielectric layer are described above. Details are not described herein again.

As shown in FIG. 27b, a plurality of vias 301 are disposed in a direction parallel to the substrate. For example, the plurality of vias 301 may be spaced from each other in a Y direction parallel to the substrate. In addition, each via 301 penetrates the plurality of semiconductor layers 10 and the plurality of dielectric layers 20.

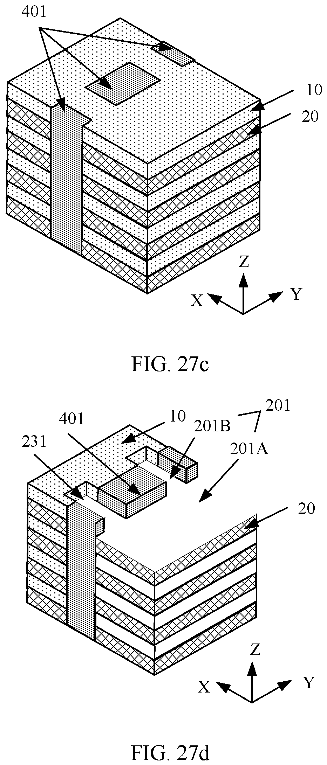

As shown in FIG. 27c, each via 301 is filled with an insulation material to form an insulation layer 401.

The insulation layer 401 in FIG. 27c may be made of one or more of insulation materials such as SiO2 (silicon dioxide), Al2O3 (aluminum oxide), HfO2 (hafnium dioxide), ZrO2 (zirconia), TiO2 (titanium dioxide), Y2O3 (yttrium oxide), and Si3N4 (silicon nitride).

As shown in FIG. 27d, a first groove 201 is disposed on any semiconductor layer 10, and the first groove 201 includes a first part 201A extending in the Y direction and a second part 201B located between two adjacent insulation layers 401.

When the via 301 shown in FIG. 27b and the first groove 201 shown in FIG. 27d are disposed, an etching process may be used.

In some optional technical processes, when the first groove 201 is disposed, as shown in FIG. 27d, the second part 201B of the first groove 201 exceeds a side surface that is of the insulation layer 401 and that is away from the first part, to form a concave cavity 231 in the semiconductor layer 10.

The concave cavity 231 formed in this structure may form the concave cavity 231 shown in FIG. 21. The concave cavity 231 is configured to extend a channel layer 13 of a first transistor T1, to reduce an area occupied by this memory cell.

With reference to FIG. 27d, a first groove 201 is disposed on each semiconductor layer 10. For example, the first groove 201 may be etched on the plurality of semiconductor layers 10 at the same time through an etching process. That is, patterning is performed on the plurality of semiconductor layers at the same time, to form a plurality of stacked memory cells at the same time.

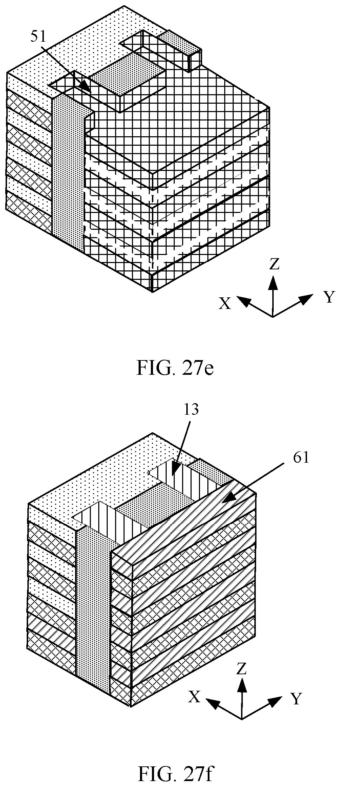

As shown in FIG. 27e, a gate dielectric layer 51 is formed on a wall surface of the first groove 201.

Because the first groove 201 is disposed on each semiconductor layer 10, gate dielectric layers 51 may be formed for wall surfaces of a plurality of first grooves 201 at the same time.

As shown in FIG. 27f, the second part 201B of the first groove 201 is filled with a semiconductor material, to form a channel layer 13 of a first transistor T1; and the first part of the first groove is filled with a conductive material, for example, a metal material, to form a first electrode line 61 that extends in the Y direction.

Same as that shown in FIG. 27d, a channel layer 13 may be formed in a second part of each of the plurality of semiconductor layers, and a first electrode line 61 may be formed in a first part of each semiconductor layer. That is, channel layers 13 of a plurality of first transistors are simultaneously formed, and a plurality of first electrode lines 61 are simultaneously formed.

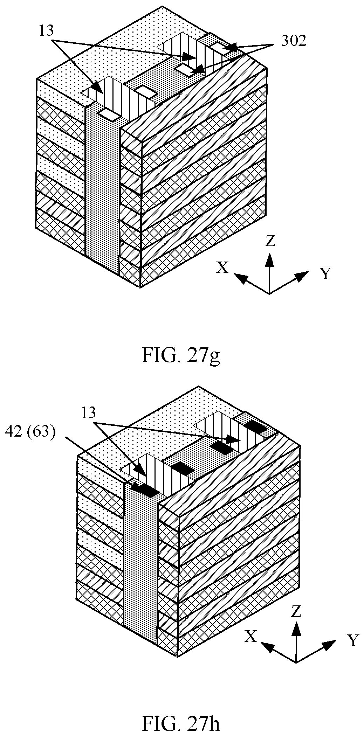

As shown in FIG. 27g, a via 302 is disposed on a side surface of the channel layer 13 of the first transistor T1 formed in FIG. 27f, and the via 302 penetrates the plurality of semiconductor layers 10 and the plurality of dielectric layers 20 in the direction perpendicular to the substrate.

Still as shown in FIG. 27g, because the gate-all-around first transistor T1 is manufactured in this embodiment of this application, vias 302 may be disposed on two opposite sides of the channel layer 13.

In some other optional processes, a via may be disposed only on one side of two opposite sides of the channel layer 13. Therefore, a formed first transistor is a single-gate transistor.

After the via 302 is disposed, as shown in FIG. 27h, the via 302 is filled with a conductive material, for example, metal, to form a third electrode line 63 electrically connected to a gate of the first transistor. For example, when a memory cell including 2T0C is manufactured, the third electrode line 63 is a write word line WWL. For another example, when a memory cell including 2TnC is manufactured, the third electrode line 63 is a pre-charge line CL.

It can be seen from FIG. 27a to FIG. 27h that, this application provides an example of two memory cells that are disposed in the Y direction. First transistors T1 of the two memory cells may be electrically isolated from each other through an insulation layer formed in FIG. 27b.

In addition, as shown in FIG. 27a to FIG. 27h, it can be seen that first transistors of a plurality of stacked memory cells may be simultaneously formed through a one-time process.

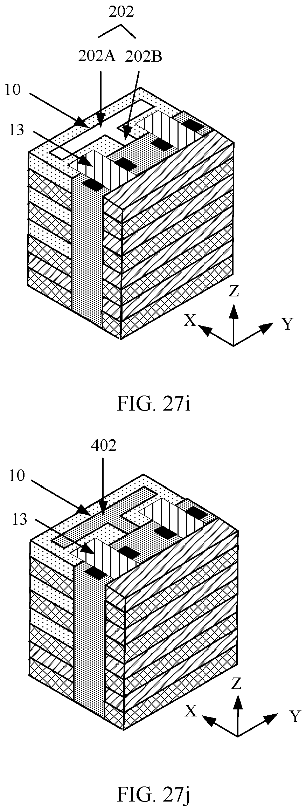

As shown in FIG. 27i, a second groove 202 is disposed on each semiconductor layer 10, and the second groove 202 includes a third part 202A extending in the Y direction and a fourth part 202B located between channel layers 13 of two adjacent first transistors T1.

As shown in FIG. 27j, both the third part 202A and the fourth part 202B are filled with an insulation material to form an insulation layer 402.

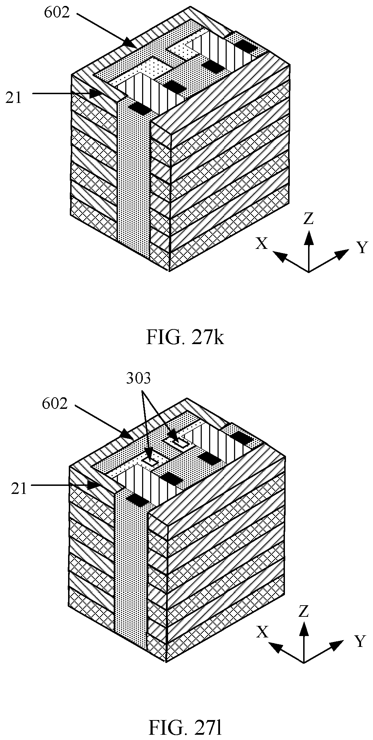

As shown in FIG. 27k, the semiconductor layer that extends in the Y direction and is adjacent to the third part of the second groove is doped, to form a second electrode line 62 that extends in the Y direction; and the semiconductor layer that is adjacent to the channel layer of the first transistor is doped, to form a first electrode 21 that is of a second transistor and that is electrically connected to the second electrode line 62.

In this implementation, the semiconductor layer is doped to form the second electrode line and the first electrode of the second transistor. In some other technical processes, a groove may also be disposed on each semiconductor layer shown in FIG. 27j, and the groove is filled with a metal material, to form the second electrode line and the first electrode of the second transistor.

As shown in FIG. 27l, vias 303 are disposed on the semiconductor layer located on two opposite sides of the fourth part of the second groove, so that the vias 303 penetrate the plurality of semiconductor layers 10 and the plurality of dielectric layers 20 in the direction perpendicular to the substrate.

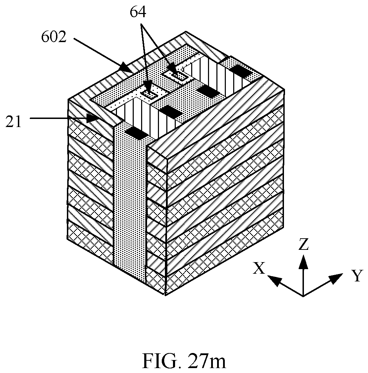

As shown in FIG. 27m, the via 303 provided in FIG. 27l is filled with a conductive material, to form a fourth electrode line 64.

It can be learned from the technical processes shown in FIG. 27a to FIG. 27m that the method includes the following processes: stacking the alternately disposed semiconductor layers and dielectric layers (as shown in FIG. 27a)-performing punching and insulation medium backfilling (as shown in FIG. 27b and FIG. 27c)→etching the semiconductor material, and performing filling to form the gate dielectric layer, the channel layer, and the first electrode line (as shown in FIG. 27d, FIG. 27e, and FIG. 27f)→performing punching and metal backfilling, to form the third electrode line (as shown in FIG. 27g and FIG. 27h)→etching the semiconductor material, to form the second electrode line and the first electrode of the second transistor (as shown in FIG. 27i, FIG. 27j, and FIG. 27k)→performing punching and metal backfilling to form the fourth electrode line (as shown in FIG. 27l and FIG. 27m). Multiple layers of stacked memory arrays may be manufactured through the technical processes shown in FIG. 27a to FIG. 27m instead of manufacturing one layer of memory array and then another layer of memory array.

If a memory is manufactured by stacking one layer of memory array and then stacking another layer of memory array, a quantity of stacked layers also increases as storage density continuously increases, and a requirement for photoetching alignment accuracy is increasingly high. If alignment accuracy between a next layer of memory array structure and a previous layer of memory array structure is low, read/write performance may be affected. However, the method for manufacturing the memory array provided in embodiments of this application has a low requirement for photoetching alignment accuracy, and does not pose a great challenge to a process. This not only can simplify a technical process and reduce process difficulty, but also can increase a product yield, improve read/write performance of the memory, and also reduce manufacturing costs of the memory.

In the descriptions of this specification, the described specific features, structures, materials, or characteristics may be combined in a proper manner in any one or more of embodiments or examples.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A memory array, comprising:
a substrate; and
a plurality of storage layers formed on the substrate, wherein the plurality of storage layers are stacked in a direction perpendicular to the substrate; and
each storage layer comprises a first electrode line and a second electrode line; and a plurality of memory cells;
each memory cell comprises a first transistor and a second transistor that are electrically connected to each other, the first transistor and the second transistor each comprise a gate, a first electrode, a second electrode, and a channel layer, the first electrode of the first transistor is electrically connected to the first electrode line, and the first electrode of the second transistor is connected to the second electrode line;
each storage layer comprises a first metal layer and a first dielectric layer that are stacked in the direction perpendicular to the substrate; and
the first electrode line, the second electrode line, and the first electrode, the second electrode, and at least a part of the channel layer of each of the first transistor and the second transistor are located in the first metal layer.

2. The memory array according to claim 1, wherein one part of the channel layer of each of the first transistor and the second transistor is located in the first metal layer, and the other part of the channel layer extends to the first dielectric layer.

3. The memory array according to claim 1 or 2, wherein the memory array further comprises a third electrode line and a fourth electrode line, wherein
both the third electrode line and the fourth electrode line extend in the direction perpendicular to the substrate;
the third electrode line is electrically connected to gates of first transistors in every two adjacent storage layers; and
the fourth electrode line is electrically connected to second electrodes of second transistors in every two adjacent storage layers.

4. The memory array according to claim 3, wherein the channel layer of the first transistor is a first channel layer, and the channel layer of the second transistor is a second channel layer;
the first channel layer and the second channel layer are arranged perpendicularly to each other; and
an extension direction of the first electrode line and an extension direction of the second electrode line are consistent with an extension direction of the second channel layer.

5. The memory array according to claim 4, wherein one end that is of the first channel layer and that is close to the second channel layer is electrically isolated from the second channel layer through a gate dielectric layer formed at an interface between the first channel layer and the second channel layer.

6. The memory array according to claim 5, wherein a concave cavity is formed at a position that is of the second channel layer and that is close to the first channel layer, and one end of the first channel layer is disposed in the concave cavity, and is electrically isolated from the second channel layer through the gate dielectric layer formed on an inner wall of the concave cavity.

7. The memory array according to claim 4, wherein the memory array further comprises a fifth electrode line, and each memory cell further comprises at least one ferroelectric capacitor;
the ferroelectric capacitor comprises a first ferroelectric electrode, a ferroelectric film layer, and a second ferroelectric electrode, the first ferroelectric electrode is electrically connected to the second electrode of the first transistor and the gate of the second transistor, and the second ferroelectric electrode is electrically connected to the fifth electrode line;
the first ferroelectric electrode is located in the first metal layer; and
the fifth electrode line extends in the direction perpendicular to the substrate.

8. The memory array according to claim 7, wherein an extension direction of the first ferroelectric electrode is consistent with an extension direction of the first channel layer, and the first ferroelectric electrode is formed at one end that is of the first channel layer and that is close to the second channel layer, and is electrically isolated from the second channel layer through a gate dielectric layer; and
the second ferroelectric electrode is disposed on a side surface of the first ferroelectric electrode, and is electrically isolated from the first ferroelectric electrode through the ferroelectric film layer.

9. The memory array according to claim 8, wherein a concave cavity is formed at a position that is of the second channel layer and that is close to the first ferroelectric electrode, and one end of the first ferroelectric electrode is disposed in the concave cavity, and is electrically isolated from the second channel layer through the gate dielectric layer formed on an inner wall of the concave cavity.

10. The memory array according to any one of claims 7 to 9, wherein each memory cell comprises a plurality of ferroelectric capacitors; and
the plurality of ferroelectric capacitors are spaced from each other in a direction parallel to the extension direction of the first channel layer.

11. The memory array according to any one of claims 4 to 10, wherein the first electrode line that is perpendicular to the extension direction of the first channel layer and that is in contact with the first channel layer is formed at one end that is of the first channel layer and that is away from the second channel layer.

12. The memory array according to any one of claims 4 to 11, wherein the third electrode line perpendicular to the substrate is formed on a side surface of the first channel layer, and the third electrode line is electrically isolated from the first channel layer through the gate dielectric layer.

13. The memory array according to any one of claims 4 to 12, wherein the first electrode of the second transistor is formed at one end in two opposite ends of the second channel layer in the extension direction of the second channel layer.

14. The memory array according to claim 13, wherein the second electrode line is located on a side that is of the second channel layer and that is away from the first channel layer; and
each memory cell further comprises a conductive connection portion, and the first electrode of the second transistor is electrically connected to the second electrode line through the conductive connection portion.

15. The memory array according to claim 14, wherein the first electrode of the second transistor, the second electrode line, and the conductive connection portion are all manufactured in a semiconductor layer through a doping process.

16. The memory array according to any one of claims 13 to 15, wherein the fourth electrode line extending in the direction perpendicular to the substrate is in contact with the other end in the two opposite ends of the second channel layer.

17. The memory array according to any one of claims 1 to 16, wherein the plurality of memory cells comprise a first memory cell and a second memory cell;
the first memory cell and the second memory cell are arranged in a direction parallel to the substrate; and
in either the first memory cell or the second memory cell, the first electrode of the first transistor is electrically connected to the first electrode line, and the first electrode of the second transistor is connected to the second electrode line.

18. The memory array according to any one of claims 1 to 17, wherein the plurality of memory cells, the first electrode line, and the second electrode line are all formed on the substrate through a back-end-of-line process.

19. The memory array according to any one of claims 1 to 6, wherein the memory array is a DRAM memory array.

20. The memory array according to claim 19, wherein the DRAM memory array further comprises a third electrode line and a fourth electrode line;
the third electrode line is electrically connected to the gate of the first transistor, and the fourth electrode line is electrically connected to the second electrode of the second transistor; and
the first electrode line is a write bit line, the second electrode line is a read bit line, the third electrode line is a write word line, and the fourth electrode line is a read word line.

21. The memory array according to any one of claims 1 to 6, wherein the memory array is a ferroelectric memory array.

22. The memory array according to claim 21, wherein the ferroelectric memory array further comprises a third electrode line and a fourth electrode line;
the third electrode line is electrically connected to the gate of the first transistor, and the fourth electrode line is electrically connected to the second electrode of the second transistor;
the ferroelectric memory array further comprises a fifth electrode line, and each memory cell further comprises at least one ferroelectric capacitor;
the ferroelectric capacitor comprises a first ferroelectric electrode, a ferroelectric film layer, and a second ferroelectric electrode, the first ferroelectric electrode is electrically connected to the second electrode of the first transistor and the gate of the second transistor, and the second ferroelectric electrode is electrically connected to the fifth electrode line; and
the first electrode line is a write bit line, the second electrode line is a read bit line, the third electrode line is a pre-charge line, the fourth electrode line is a source line, and the fifth electrode line is a word line.

23. A memory, comprising:
the memory array according to any one of claims 1 to 22; and
a controller, wherein the controller is electrically connected to the memory array, and the controller is configured to control reading/writing of the memory array.

24. An electronic device, comprising:
a processor; and
the memory according to claim 23, wherein the processor is electrically connected to the memory, and the memory is configured to store data generated by the processor.

25. A method for forming a memory array, wherein the forming method comprises:
forming a plurality of semiconductor layers and a plurality of dielectric layers on a substrate, wherein the plurality of semiconductor layers and the plurality of dielectric layers are alternately stacked in a direction perpendicular to the substrate; and
performing patterning processing on each semiconductor layer to form a first electrode line, a second electrode line, and a memory cell comprising a first transistor and a second transistor, wherein
the first transistor and the second transistor each comprise a first electrode, a second electrode, a gate, and a channel layer, the first electrode of the first transistor is electrically connected to the first electrode line, the first electrode of the second transistor is electrically connected to the second electrode line, the first electrode line, the second electrode line, and the first electrode, the second electrode, and at least a part of the channel layer of each of the first transistor and the second transistor are located in a first metal layer, and the first metal layer is parallel to the dielectric layer.

26. The method for forming the memory array according to claim 25, wherein before the performing patterning processing on each semiconductor layer to form a first electrode line, a second electrode line, and a memory cell comprising a first transistor and a second transistor, the forming method further comprises:
disposing a plurality of first vias, wherein the plurality of first vias are spaced from each other in a first direction, and any first via penetrates the plurality of semiconductor layers and the plurality of dielectric layers in the direction perpendicular to the substrate; and
filling the first via with an insulation layer.

27. The method for forming the memory array according to claim 26, wherein the performing patterning processing on each semiconductor layer to form a first electrode line, a second electrode line, and a memory cell comprising a first transistor and a second transistor comprises:
disposing a first groove on each semiconductor layer, wherein the first groove comprises a first part extending in the first direction and a second part located between two adjacent insulation layers;
forming a gate dielectric layer on a wall surface of the first groove;
filling the second part with a semiconductor material, to form the channel layer of the first transistor; and
filling the first part with a conductive material, to form the first electrode line extending in the first direction.

28. The method for forming the memory array according to claim 27, wherein the disposing a first groove on each semiconductor layer, wherein the first groove comprises a first part extending in the first direction and a second part located between two adjacent insulation layers comprises:
exceeding, by the second part, a side surface that is of the insulation layer and that is away from the first part, to form a concave cavity in the semiconductor layer, so that the channel layer of the first transistor is disposed in the concave cavity.

29. The method for forming the memory array according to claim 27 or 28, wherein the performing patterning processing on each semiconductor layer to form a first electrode line, a second electrode line, and a memory cell comprising a first transistor and a second transistor further comprises:
disposing a second groove on each semiconductor layer, wherein the second groove comprises a third part extending in the first direction and a fourth part located between channel layers of two adjacent first transistors; and
filling both the third part and the fourth part with an insulation layer.

30. The method for forming the memory array according to claim 29, wherein after the disposing a second groove on each semiconductor layer, the forming method further comprises:
doping the semiconductor layer that extends in the first direction and that is adjacent to the third part of the second groove, to form the second electrode line extending in the first direction, and doping the semiconductor layer that is adjacent to the channel layer of the first transistor, to form the first electrode that is of the second transistor and that is electrically connected to the second electrode line.

31. The method for forming the memory array according to claim 29 or 30, wherein the forming method further comprises:
disposing a third via on a side surface of the channel layer of the first transistor, so that the third via penetrates the plurality of semiconductor layers and the plurality of dielectric layers in the direction perpendicular to the substrate; and
filling the third via with a conductive material, to form a third electrode line electrically connected to the gate of the first transistor.

32. The method for forming the memory array according to any one of claims 29 to 31, wherein the forming method further comprises:
disposing second vias on the semiconductor layer on two opposite sides of the fourth part, so that the second vias penetrate the plurality of semiconductor layers and the plurality of dielectric layers in the direction perpendicular to the substrate; and
filling the second via with a conductive material, to form a fourth electrode line electrically connected to the second electrode of the second transistor.
